# EUROPEAN PATENT APPLICATION

(11) **EP 2 530 099 A1**
(43) Date of publication of application: **05.12.2012**
(21) Application number: 11737122.9
(22) Date of filing: 27.01.2011
(51) Int. Cl.: C08G 61/10, C08G 61/12, C09K 11/06, H01L 51/50

(54) **POLYMER COMPOUND, METHOD FOR PRODUCING SAME, AND LIGHT-EMITTING ELEMENT USING THE POLYMER COMPOUND**

(30) Priority: 29.01.2010 JP 2010018804
(71) Applicant: Sumitomo Chemical Co., Ltd, Chuo-ku, Tokyo 104-8260 (JP)
(72) Inventor: YOSHIDA Tomoyasu, Tsukuba-shi Ibaraki 305-0817 (JP); HANAOKA Hidenori, Suita-shi Osaka 565-0874 (JP); MORIWAKI Shota, Ibaraki-shi Osaka 567-0826 (JP)
(74) Representative: Duckworth, Timothy John
(86) International application number: PCT/JP2011/051666
(87) International publication number: WO 2011/093411

(57) **Abstract**

A polymer compound comprising a constitutional unit represented by the following formula (1-1) and/or formula (2-1); 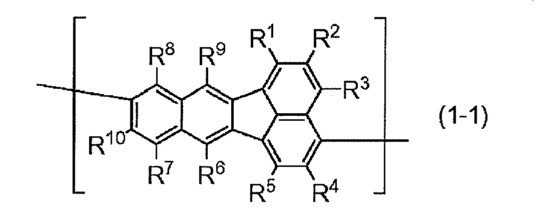 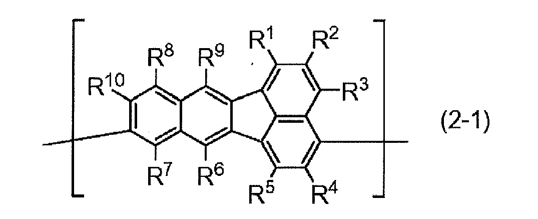 wherein R¹, R², R³, R⁴, R⁵, R⁶, R⁷, R⁸, R⁹ and R¹⁰ each independently represent a hydrogen atom, an optionally substituted alkyl group, an optionally substituted aryl group, an optionally substituted monovalent aromatic heterocyclic group, or the group -O-R^{A}; where R^{A} represents an optionally substituted alkyl group, an optionally substituted aryl group or an optionally substituted monovalent aromatic heterocyclic group, and when multiple R^{A} groups are present, the R^{A} groups may be the same or different.

## Description

### Technical Field

The present invention relates to a polymer compound, to a method and a starting compound for producing it, and to a polymer composition, solution, organic film, light-emitting device, surface light source and display device comprising it.

### Background Art

Examples of light-emitting materials that have been studied for use in light-emitting devices include polymer compounds comprising repeating units of fluoranthene derivative divalent groups (specifically, compounds wherein 2 bonding sites of each of the constitutional units represented by formula (1-1) and/or formula (2-1) below extend from the position of either or both R⁶ and R⁹) (Patent document 1).

### Citation List

### Patent Literature

[Patent document 1] International Patent Publication No. WO2009/075203

### Summary of Invention

### Technical Problem

However, light-emitting devices employing conventional polymer compounds have not always been adequate in terms of light-emitting efficiency.

It is therefore an object of the present invention to provide a polymer compound that is useful for production of a light-emitting device with excellent light-emitting efficiency. It is another object of the invention to provide a polymer composition, solution, organic film, light-emitting device, surface light source and display device comprising the polymer compound. It is yet another object of the invention to provide a method and a starting compound for producing the polymer compound.

### Solution to Problem

Specifically, the invention provides a polymer compound comprising a constitutional unit represented by the following formula (1-1) and/or formula (2-1); 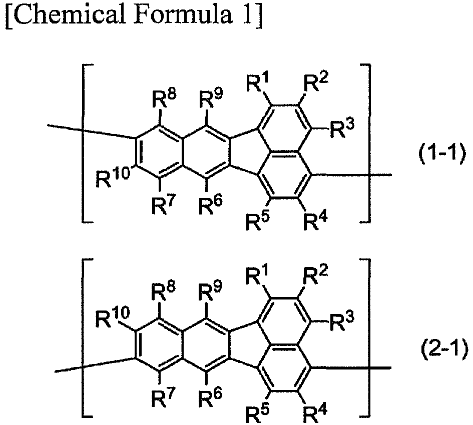 wherein R¹, R², R³, R⁴, R⁵, R⁶, R⁷, R⁸, R⁹ and R¹⁰ each independently represent a hydrogen atom, an optionally substituted alkyl group, an optionally substituted aryl group, an optionally substituted monovalent aromatic heterocyclic group, or a group represented by -O-R^{A}, where R^{A} represents an optionally substituted alkyl group, an optionally substituted aryl group or an optionally substituted monovalent aromatic heterocyclic group, and when multiple R^{A} groups are present, the R^{A} groups may be the same or different.

Such a polymer compound will yield a light-emitting device with excellent light-emitting efficiency.

The polymer compound of the invention preferably has an optionally substituted arylene group or an optionally substituted divalent aromatic heterocyclic group bonded to at least one of the two bonding sites of each of the constitutional units represented by the formula (1-1) and/or formula (2-1). Such a polymer compound will yield a light-emitting device with even more excellent light-emitting efficiency.

Also, in the polymer compound of the invention, the arylene group is preferably a 2,7-fluorenediyl group. Such a polymer compound will yield a light-emitting device with even more excellent light-emitting efficiency.

Also, in the polymer compound of the invention, the arylene group is preferably a 1,3-phenylene or 1,4-phenylene group, and more preferably a 1,3-phenylene group.

In the polymer compound of the invention, R⁶ and R⁹ in the formula (1-1) and formula (2-1) are preferably an optionally substituted aryl group or an optionally substituted monovalent aromatic heterocyclic group. Such a polymer compound will yield a light-emitting device with even more excellent light-emitting efficiency.

The polymer compound of the invention also preferably comprises a first constitutional unit represented by formula (1-1) and/or formula (2-1), a second constitutional unit represented by the following formula (3), and at least one constitutional unit selected from the group consisting of a third constitutional unit represented by the following formula (4) and a fourth constitutional unit represented by the following formula (5); 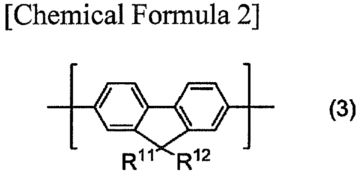 wherein R¹¹ and R¹² each independently represent an optionally substituted alkyl group, an optionally substituted aryl group or an optionally substituted monovalent aromatic heterocyclic group; 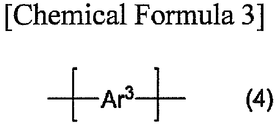 wherein Ar³ represents an arylene group having one or more optional substituents selected from among substituent group X, a divalent aromatic heterocyclic group having one or more optional substituents selected from among substituent group X, or a divalent group in which 2 or more of the same or different groups selected from the group consisting of arylene groups and divalent aromatic heterocyclic groups, are linked, where the divalent group may have one or more substituents selected from among substituent group X;

### <Substituent group X>

An alkyl group, an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a group represented by -N(R^{A})₂, a cyano group and a fluorine atom; where R^{A} is as defined above, and when multiple R^{A} groups are present, the R^{A} groups may be the same or different; 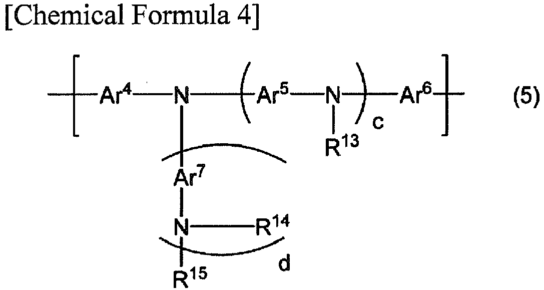 wherein Ar⁴, Ar⁵, Ar⁶ and Ar⁷ each independently represent an optionally substituted arylene group, an optionally substituted divalent aromatic heterocyclic group, or an optionally substituted divalent group in which 2 or more arylene groups or divalent aromatic heterocyclic groups are linked; R¹³, R¹⁴ and R¹⁵ each independently represent a hydrogen atom, an alkyl group, an aryl group, a monovalent heterocyclic group or an arylalkyl group; c represents an integer of 0-3, and d represents 0 or 1.

The polymer compound of the invention also preferably comprises a first constitutional unit represented by the formula (1-1) and/or formula (2-1), a second constitutional unit represented by the following formula (3), and a fourth constitutional unit represented by the following formula (5); 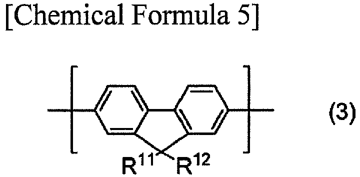 wherein R¹¹ and R¹² have the same respective defmitions as above; 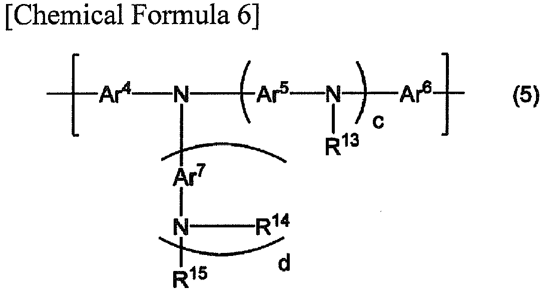 wherein Ar⁴, Ar⁵, Ar⁶, Ar⁷, R¹³, R¹⁴, R¹⁵, c and d have the same respective definitions as above.
Such a polymer compound will yield a light-emitting device with even more excellent light-emitting efficiency.

The polymer compound of the invention is preferably a conjugated polymer compound. Such a polymer compound will yield a light-emitting device with even more excellent light-emitting efficiency.

The total content of the first constitutional unit represented by the formula (1-1) and formula (2-1) in the polymer compound of the invention is preferably between 0.1 mol% and 20 mol%, based on the total content of the first constitutional unit, the second constitutional unit, the third constitutional unit and the fourth constitutional unit. Such a polymer compound will yield a light-emitting device with even more notably excellent light-emitting efficiency.

The total content of the first constitutional unit, the second constitutional unit, the third constitutional unit and the fourth constitutional unit in the polymer compound is preferably 80 wt% or greater, based on the total polymer compound. The effect of the polymer compound will thereby be exhibited even more prominently.

There is further provided a compound (monomer) represented by the following formula (6) and/or formula (7); 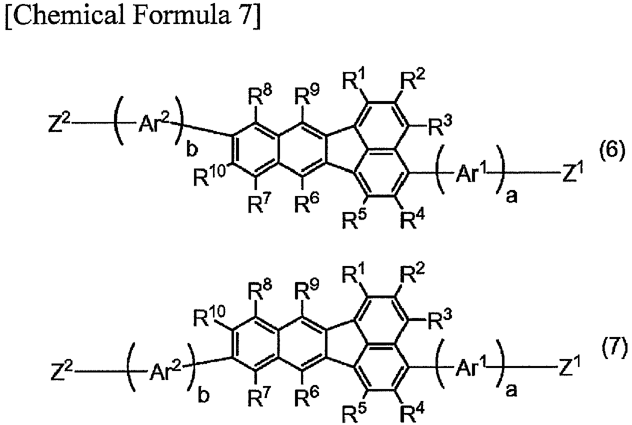 wherein R¹, R², R³, R⁴, R⁵, R⁶, R⁷, R⁸, R⁹ and R¹⁰ have the same respective definitions as above, Ar¹ and Ar² each independently represent an optionally substituted arylene group or an optionally substituted divalent aromatic heterocyclic group, and a and b each independently represent 0 or 1;
Z¹ and Z² each independently represent substituent group A or substituent group B;

### <Substituent group A>

A chlorine atom, a bromine atom, an iodine atom and a group represented by -O-S(=O)₂R¹⁶, where R¹⁶ represents an optionally substituted alkyl group, or an aryl group optionally substituted with an alkyl group, an alkoxy group, an nitro group, a fluorine atom or a cyano group;

### <Substituent group B>

A Group represented by -B(OR¹⁷)₂, where R¹⁷ represents a hydrogen atom or an alkyl group, and the two R¹⁷ groups may be the same or different and may be bonded together to form a ring,
a group represented by -BF₄Q¹, where Q¹ represents a monovalent cation of lithium, sodium, potassium, rubidium or cesium,
a group represented by -MgY¹, where Y¹ represents a chlorine atom, a bromine atom or an iodine atom,
a group represented by -ZnY², where Y² represents a chlorine atom, a bromine atom or an iodine atom, and
a group represented by -Sn(R¹⁸)₃, where R¹⁸ represents a hydrogen atom or an alkyl group, and the three R¹⁸ groups may be the same or different and may be bonded together to form a ring.
Such compounds are useful as starting monomers for production of the aforementioned polymer compound.

In the polymer compound of the invention, R⁶ and R⁹ in the formula (6) and/or formula (7) are preferably each independently an optionally substituted aryl group or an optionally substituted monovalent aromatic heterocyclic group. Such compounds are more useful as starting monomers for production of the aforementioned polymer compound.

The invention further provides a method for producing the aforementioned polymer compound, by polymerization of a monomer composition comprising a first monomer represented by the following formula (6) and/or formula (7), and a second monomer represented by the following formula (3M); 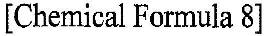 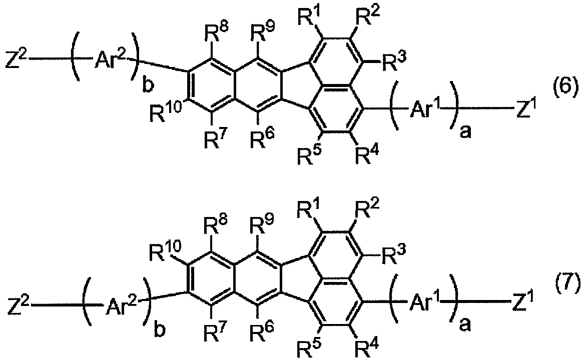 wherein R¹, R², R³, R⁴, R⁵, R⁶, R⁷, R⁸, R⁹, R¹⁰, Ar¹, Ar², a, b, Z¹ and Z² have the same definitions as above; 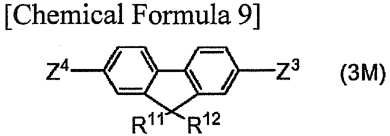 wherein R¹¹ and R¹² have the same respective definitions as above, and Z³ and Z⁴ each independently represent substituent group A or substituent group B above.

The invention further provides a polymer composition comprising the aforementioned polymer compound and at least one material selected from the group consisting of hole transport materials, electron transport materials and light-emitting materials. Such a polymer composition can be suitably used for production of a light-emitting device, and the obtained light-emitting device has excellent light-emitting efficiency.

The invention still further provides a solution comprising the aforementioned polymer compound or the aforementioned polymer composition. Such a solution allows easy production of an organic film comprising the aforementioned polymer compound.

The invention still further provides an organic film comprising the aforementioned polymer compound or the aforementioned polymer composition. Such an organic film is useful for production of light-emitting devices with excellent light-emitting efficiency.

The invention further provides a light-emitting device comprising the organic film. A light-emitting device produced using the polymer compound has excellent light-emitting efficiency.

The invention still further provides a surface light source and a display device employing the aforementioned light-emitting device with excellent light-emitting efficiency.

### Advantageous Effects of Invention

According to the invention, it is possible to provide a polymer compound that is useful for production of a light-emitting device with excellent light-emitting efficiency. The invention can also provide a polymer composition, solution, organic film, light-emitting device, surface light source and display device comprising the polymer compound. The invention can still further provide a method for producing the polymer compound and a starting compound for the polymer compound.

### Description of Embodiments

Preferred embodiments of the invention will now be described in detail.

Throughout the present specification, the term "constitutional unit" refers to a unit structure of which at least one is present in the polymer compound. The "constitutional unit" is preferably present in the polymer compound as a "repeating unit" (that is, a unit structure of which 2 or more are present in the polymer compound). The phrase "n-valent aromatic heterocyclic group" means an atomic group derived by removing n hydrogen atoms directly bonded to the aromatic ring of a heterocyclic compound having aromaticity, and it includes those having a fused ring structure. The term "heterocyclic compound," includes organic compounds with a ring structure that contain heteroatoms such as oxygen atoms, sulfur atoms, nitrogen atoms, phosphorus atoms, boron atoms and silicon atoms, as atoms composing the ring in addition to carbon atoms. An "aromatic heterocyclic compound" is a heterocyclic compound containing a heteroatom, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole or dibenzophosphole, and it includes those wherein the heterocyclic ring itself is aromatic, and those wherein the heterocyclic ring itself containing a heteroatom is not aromatic but an aromatic ring is fused to the heterocyclic ring, such as phenoxazine, phenothiazine, dibenzoborole, dibenzosilol or benzopyran. An "n-valent fused aromatic heterocyclic group" is the aforementioned "n-valent aromatic heterocyclic group" having a fused ring. Me represents a methyl group, Et represents an ethyl group, Bu represents a butyl group and Ph represents a phenyl group. As used herein, "arylene group" does not include groups represented by formula (1-1) and formula (2-1).

### <Polymer compound>

### [First constitutional unit]

The polymer compound of this embodiment comprises a constitutional unit (first constitutional unit) represented by the following formula (1-1) and/or formula (2-1). 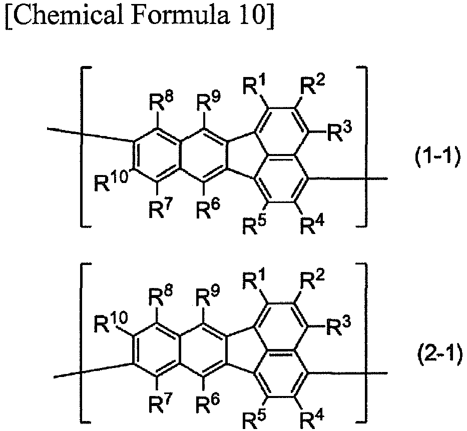 In formula (1-1) and formula (2-1), R¹, R², R³, R⁴, R⁵, R⁶, R⁷, R⁸, R⁹ and R¹⁰ (hereunder referred to as "R¹-R¹⁰") each independently represent a hydrogen atom, an optionally substituted alkyl group, an optionally substituted aryl group, an optionally substituted monovalent aromatic heterocyclic group, or a group represented by -O-R^{A} (where R^{A} represents an optionally substituted alkyl group, an optionally substituted aryl group or an optionally substituted monovalent aromatic heterocyclic group, and when multiple R^{A} groups are present, the R^{A} groups may be the same or different).

Both of the constitutional units represented by formula (1-1) and formula (2-1) may be present in the polymer compound.

In formula (1-1) and formula (2-1), the alkyl groups of R¹-R¹⁰ may be straight-chain, branched or cyclic, and will usually have 1-20 and preferably 1-12 carbon atoms. The number of carbons of the substituents are not included in this number of carbon atoms. Examples of such alkyl groups include methyl, ethyl, propyl, isopropyl, butyl, isobutyl, tert-butyl, pentyl, isoamyl, hexyl, cyclohexyl, heptyl, octyl, 2-ethylhexyl, nonyl, decyl, 3,7-dimethyloctyl and dodecyl. The hydrogen atoms of the alkyl groups may be optionally substituted with aryl groups, monovalent aromatic heterocyclic groups, groups represented by -O-R^{A}, groups represented by -S-R^{A}, groups represented by -C(=O)-R^{A}, groups represented by -C(=O)-O-R^{A}, cyano groups, fluorine atoms, or the like. Examples of alkyl groups substituted with fluorine atoms include trifluoromethyl, pentafluoroethyl, perfluorobutyl, perfluorohexyl and perfluorooctyl groups.

In formula (1-1) and formula (2-1), the aryl groups of R¹-R¹⁰ are atomic groups derived by removing 1 hydrogen atom directly bonded to the aromatic ring of an aromatic hydrocarbon, and they include those with fused rings. The number of carbon atoms of the aryl group will usually be 6-60, and is preferably 6-48, more preferably 6-20 and even more preferably 6-14. The number of carbons of the substituents are not included in this number of carbon atoms. Such aryl groups include phenyl, 1-naphthyl, 2-naphthyl, 1-anthracenyl, 2-anthracenyl, 9-anthracenyl, 1-tetracenyl, 2-tetracenyl, 5-tetracenyl, 1-pyrenyl, 2-pyrenyl, 4-pyrenyl, 2-perylenyl, 3-perylenyl, 2-fluorenyl, 3-fluorenyl, 4-fluorenyl, 1-biphenylyl, 2-biphenylyl, 2-phenanthrenyl, 9-phenanthrenyl, 6-chrysenyl and 1-coronenyl. The hydrogen atoms of the aryl groups may be optionally substituted with an alkyl group, an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a cyano group, a fluorine atom, or the like.

In formula (1-1) and formula (2-1), the monovalent aromatic heterocyclic groups of R¹-R¹⁰ have usually 3-60 and preferably 3-20 carbon atoms. The number of carbons of the substituents are not included in this number of carbon atoms. Such monovalent aromatic heterocyclic groups include 1,3,4-oxadiazol-2-yl, 1,3,4-thiadiazol-2-yl, 2-thiazolyl, 2-oxazolyl, 2-thienyl, 2-pyrrolyl, 2-furyl, 2-pyridyl, 3-pyridyl, 4-pyridyl, 2-pyrazinyl, 2-pyrimidinyl, 2-triazinyl, 3-pyridazinyl, 5-quinolyl, 5-isoquinolyl, 2-carbazolyl, 3-carbazolyl, 2-phenoxazinyl, 3-phenoxazinyl, 2-phenothiazinyl and 3-phenothiazinyl. The hydrogen atoms of the monovalent aromatic heterocyclic groups may be optionally substituted with alkyl groups, aryl groups, monovalent aromatic heterocyclic groups, groups represented by -O-R^{A}, groups represented by -S-R^{A}, groups represented by -C(=O)-R^{A}, groups represented by -C(=O)-O-R^{A}, cyano groups, fluorine atoms, or the like.

Examples of the alkyl groups, aryl groups and monovalent aromatic heterocyclic groups for R^{A} are the same as the groups for R¹ mentioned above.

In formula (1-1) and formula (2-1), the groups represented by "-O-R^{A}" in R¹-R¹⁰, when R^{A} is an alkyl group, may be alkoxy groups with straight-chain, branched or cyclic alkyl groups. The number of carbon atoms of the alkoxy group will usually be 1-20 and is preferably 1-12. Such alkoxy groups include methoxy, ethoxy, propyloxy, isopropyloxy, butoxy, isobutoxy, tert-butoxy, pentyloxy, hexyloxy, nonyloxy, decyloxy, 3,7-dimethyloctyloxy, dodecyloxy, trifluoromethoxy, pentafluoroethoxy, perfluorobutoxy, perfluorohexyloxy, perfluorooctyloxy, methoxymethyloxy, 2-methoxyethyloxy and 2-ethoxyethyloxy.

In formula (1-1) and formula (2-1), the groups represented by "-O-R^{A}" in R¹-R¹⁰, when R^{A} is an aryl group, may be aryloxy groups with usually 6-60 and preferably 6-30 carbon atoms. The aryl group portion may be any of the same aryl groups represented by R¹. More specifically, such aryloxy groups include phenoxy, C₁-C₁₂ alkoxyphenoxy ("C₁-C₁₂ alkoxy" means 1-12 carbon atoms in the alkoxy portion, same hereunder), C₁-C₁₂ alkylphenoxy ("C₁-C₁₂ alkyl" means 1-12 carbon atoms in the alkyl portion, same hereunder), 1-naphthyloxy, 2-naphthyloxy and pentafluorophenyloxy.

Also, in formula (1-1) and formula (2-1), the groups represented by "-O-R^{A}" in R¹-R¹⁰, when R^{A} is a monovalent aromatic heterocyclic group, may be groups with usually 3-60 and preferably 3-20 carbon atoms. The monovalent aromatic heterocyclic groups may be any of the same as the monovalent aromatic heterocyclic groups for R¹ mentioned above.

In formula (1-1) and formula (2-1), R¹-R¹⁰ are preferably hydrogen atoms, optionally substituted alkyl groups or optionally substituted aryl groups. This will improve the stability of the polymer compound of this embodiment.

In order to improve the stability of the polymer compound of this embodiment and further improve the light-emitting efficiency of a light-emitting device employing the polymer compound, R³ and R¹⁰ in formula (1-1) and formula (2-1) are more preferably hydrogen atom.

In formula (1-1) and formula (2-1), R⁶ and R⁹ are preferably optionally substituted alkyl groups, optionally substituted aryl groups or optionally substituted monovalent aromatic heterocyclic groups, more preferably optionally substituted aryl groups or optionally substituted monovalent aromatic heterocyclic groups and even more preferably optionally substituted aryl groups, for more excellent light-emitting efficiency by the obtained light-emitting device. This will facilitate monomer synthesis and improve the stability of the polymer compound of this embodiment.

Specific examples for the first constitutional unit include structures represented by the following formulas (1-001) to (1-022) and formulas (2-001) to (2-022).

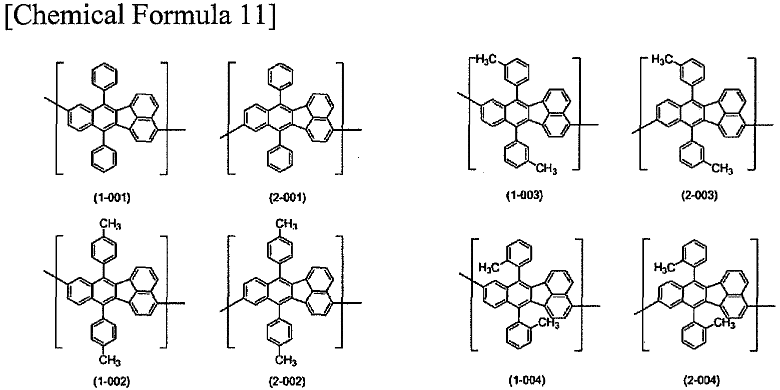

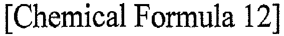

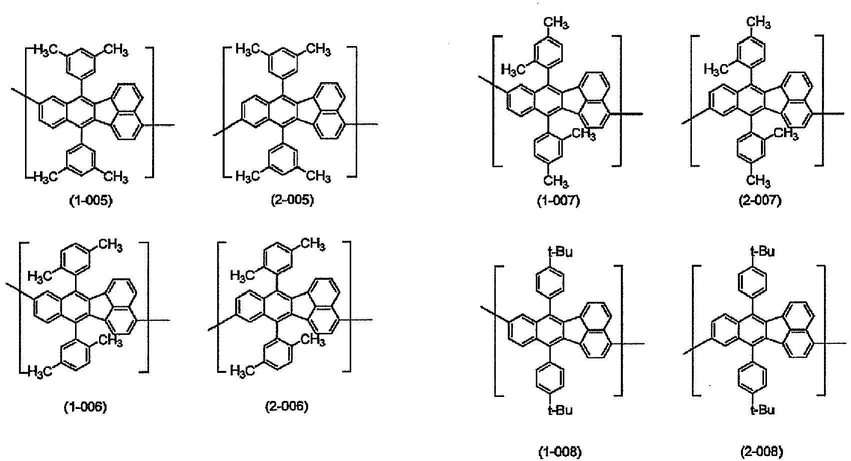

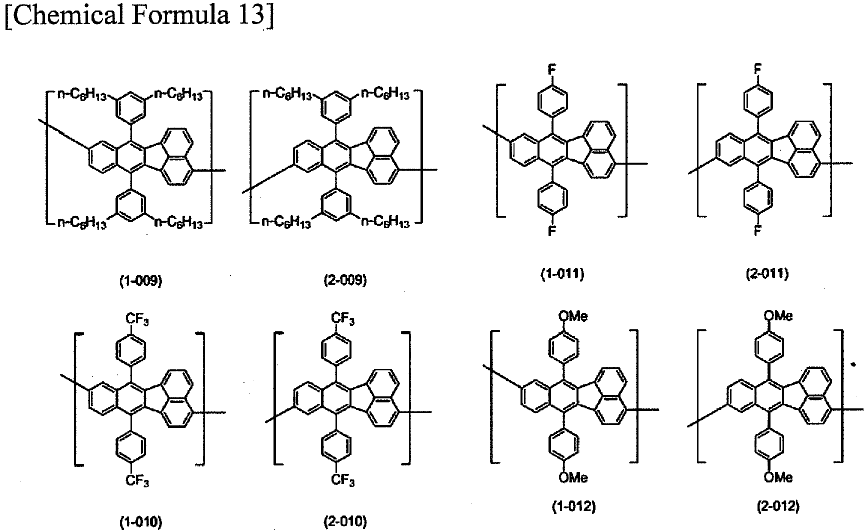

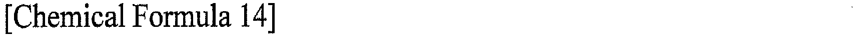

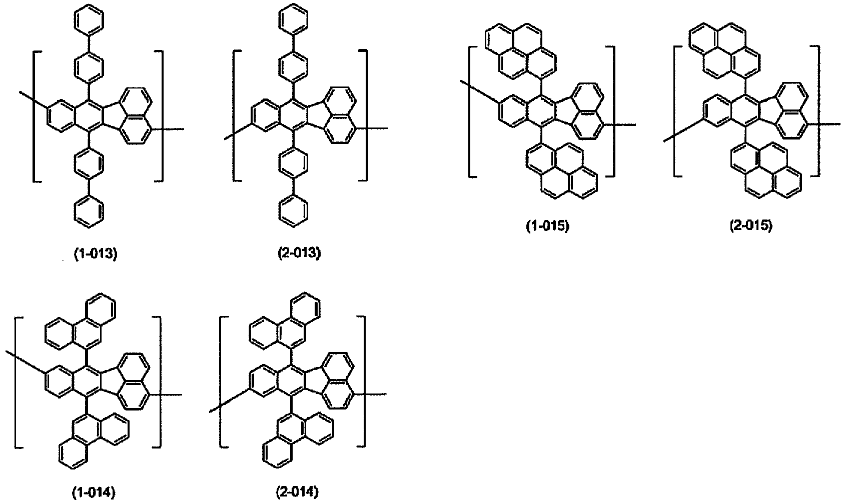

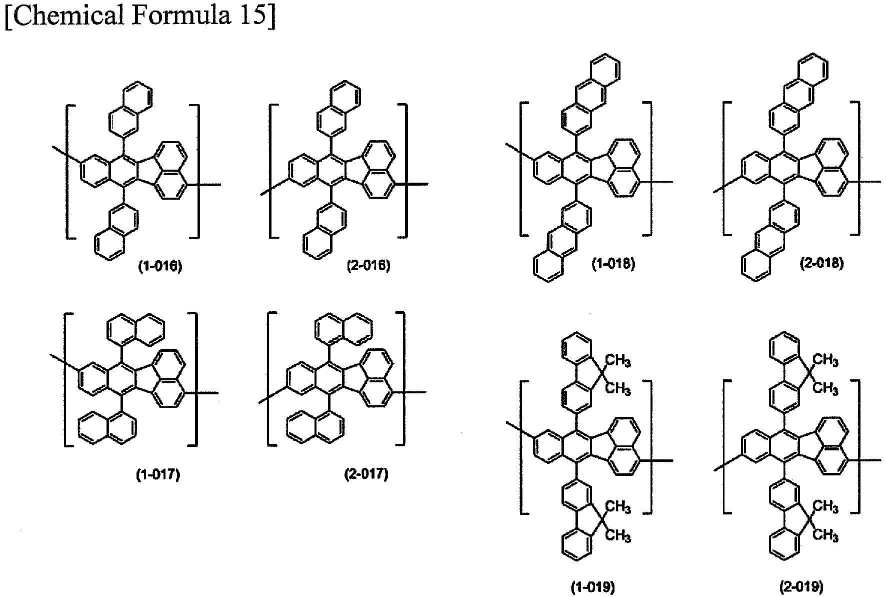

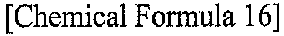

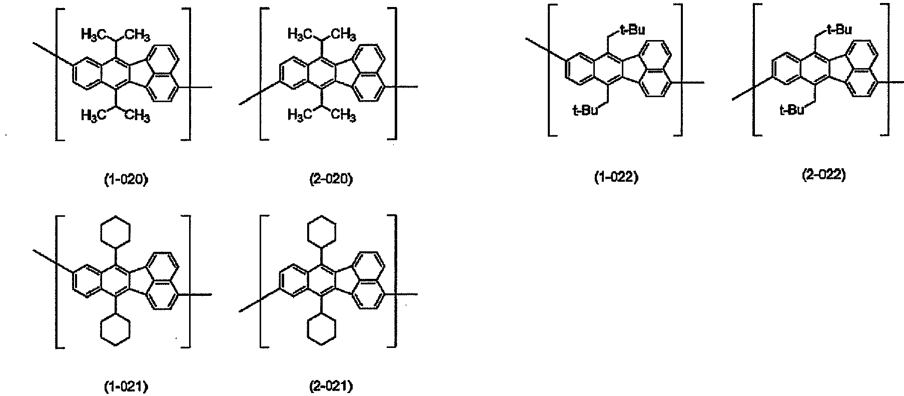

The polymer compound of this embodiment preferably has an optionally substituted arylene group or an optionally substituted divalent aromatic heterocyclic group bonded to at least one of the two bonding sites of each of the constitutional units represented by formula (1-1) and/or formula (2-1). Specific examples of optionally substituted arylene groups include constitutional units represented by the following formulas (1'-001) to (1'-011). 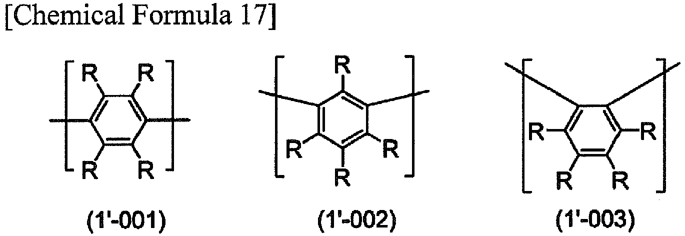 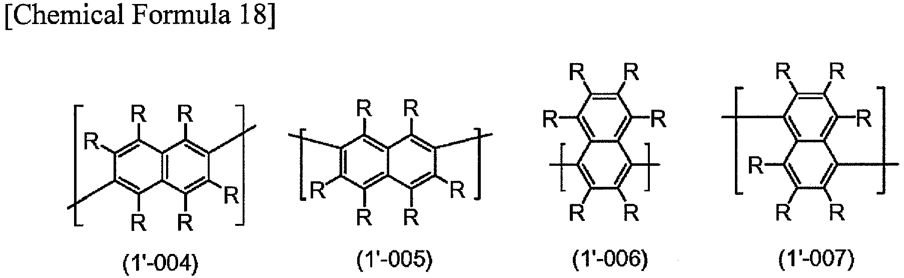 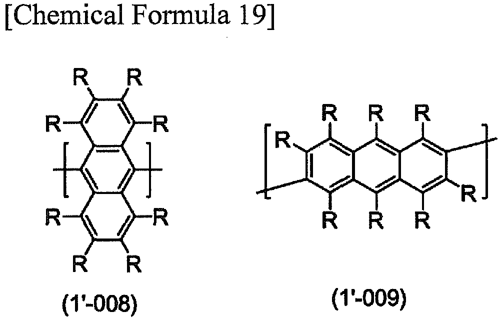 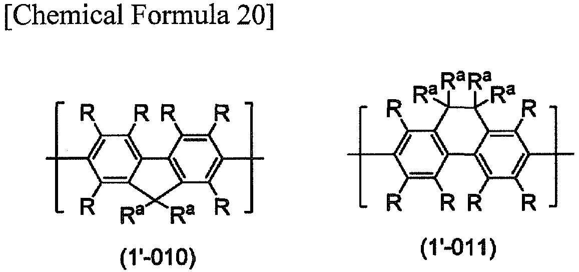 In the formulas, R represents a hydrogen atom or a group from among substituent group X, R^{a} represents an alkyl group, an aryl group or a monovalent aromatic heterocyclic group, which may have optional substituents, and multiple R groups may be the same or different and multiple R^{a} groups may be the same or different.

Of these, 1,4-phenylene (formula (1'-001)), 1,3-phenylene (formula (1'-002)) and 2,7-fluorenediyl (formula (1'-010)) are preferred.

Specific examples of optionally substituted divalent aromatic heterocyclic groups include the same substituents as the divalent aromatic heterocyclic groups (4-101) to (4-117) represented by Ar³, described hereunder.

The first constitutional unit may be a single type or two or more types in the polymer compound of this embodiment.

### [Second constitutional unit]

A polymer compound according to this embodiment preferably comprises a constitutional unit represented by formula (3) (second constitutional unit).

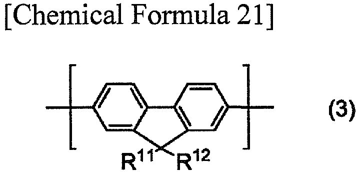

In formula (3), R¹¹ and R¹² each independently represent an optionally substituted alkyl group, an optionally substituted aryl group or an optionally substituted monovalent aromatic heterocyclic group.

In formula (3), the alkyl groups for R¹¹ and R¹² may be the same alkyl groups as for R¹ mentioned above, but are preferably methyl, ethyl, propyl, isopropyl, butyl, sec-butyl, isobutyl, pentyl, 2-methylbutyl, isoamyl, hexyl, heptyl, octyl, 2-ethylhexyl, nonyl, decyl, 3,7-dimethyloctyl or dodecyl groups.

In formula (3), the aryl groups for R¹¹ and R¹² may be the same aryl groups as for R¹ mentioned above, but are preferably optionally substituted phenyl groups, optionally substituted 1-naphthyl groups or optionally substituted 2-naphthyl groups.

Monovalent aromatic heterocyclic groups for R¹¹ and R¹² in formula (3) include the same monovalent aromatic heterocyclic groups for R¹ mentioned above.

Groups for R¹¹ and R¹² in formula (3) are preferably optionally substituted aryl groups or optionally substituted alkyl groups, more preferably aryl groups optionally substituted with alkyl groups, alkoxy groups, aryl groups or substituted amino groups, or alkyl groups optionally substituted with alkyl groups, alkoxy groups, aryl groups or substituted amino groups, and more preferably 4-tolyl, 4-butylphenyl, 4-tert-butylphenyl, 4-hexylphenyl, 4-octylphenyl, 4-(2-ethylhexyl)phenyl, 4-(3,7-dimethyloctyl)phenyl, 3-tolyl, 3-butylphenyl, 3-tert-butylphenyl, 3-hexylphenyl, 3-octylphenyl, 3-(2-ethylhexyl)phenyl, 3-(3,7-dimethyloctyl)phenyl, benzyl, 3,5-dimethylphenyl, 3,5-di-(tert-butyl)phenyl, 3,5-dihexylphenyl, 3,5-dioctylphenyl, 3,4-dihexylphenyl, 3,4-dioctylphenyl, 4-hexyloxyphenyl, 4-octyloxyphenyl, 4-(2-ethoxy)ethoxyphenyl, 4-(4'-tert-butylbiphenylyl), 9,9-dihexylfluoren-2-yl, 9,9-dioctylfluoren-2-yl, pentyl, hexyl, 2-ethylhexyl, octyl or 3,7-dimethyloctyl groups, for more satisfactory heat resistance and solubility of the polymer compound of this embodiment.

The second constitutional unit may be a single type or two or more types in the polymer compound of this embodiment.

### [Third constitutional unit]

The polymer compound of this embodiment preferably comprises a constitutional unit represented by formula (4): 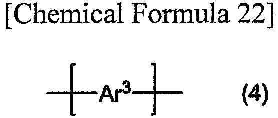 (third constitutional unit: different from the constitutional unit represented by formula (3) above).

In formula (4), Ar³ represents arylene having one or more optional substituents selected from among substituent group X, a divalent aromatic heterocyclic group having one or more optional substituents selected from among substituent group X, or a divalent group in which 2 or more of the same or different groups selected from the group consisting of arylene and divalent aromatic heterocyclic groups, are linked (the divalent group may have one or more substituents selected from among substituent group X). Here, "substituent group X" consists of alkyl groups, aryl groups, monovalent aromatic heterocyclic groups, groups represented by -O-R^{A}, groups represented by -S-R^{A}, groups represented by -C(=O)-R^{A}, groups represented by -C(=O)-O-R^{A}, groups represented by -N(R^{A})₂, cyano groups and fluorine atoms. When multiple R^{A} groups are present, the R^{A} groups may be the same or different.

The arylene group for Ar³ in formula (4) has usually 6-60, preferably 6-48, more preferably 6-30 and even more preferably 6-14 carbon atoms. The number of carbons of the substituents are not included in this number of carbon atoms. Arylene groups include phenylene groups such as 1,4-phenylene (formula (4-001)), 1,3-phenylene (formula (4-002)) and 1,2-phenylene (formula (4-003)); naphthalenediyl groups such as naphthalene-1,4-diyl (formula (4-004)), naphthalene-1,5-diyl (formula (4-005)), naphthalene-2,6-diyl (formula (4-006)) and naphthalene-2,7-diyl (formula (4-007)); dihydrophenanthrenediyl groups such as 4,5-dihydrophenanthrene-2,7-diyl (formula (4-008)); fluorene-3,6-diyl (formula (4-009)); benzofluorenediyl groups represented by (formula (4-010) to (formula (4-012)); and anthracenediyl groups such as anthracene-2,6-diyl (formula (4-013)) and anthracene-9,10-diyl (formula (4-014)). The hydrogen atoms in these arylene groups may be substituted with alkyl groups, aryl groups and monovalent aromatic heterocyclic groups, groups represented by -O-R^{A}, groups represented by -S-R^{A}, groups represented by -C(=O)-R^{A}, groups represented by -C(=O)-O-R^{A}, groups represented by -N(R^{A})₂, cyano groups, fluorine atoms and the like. 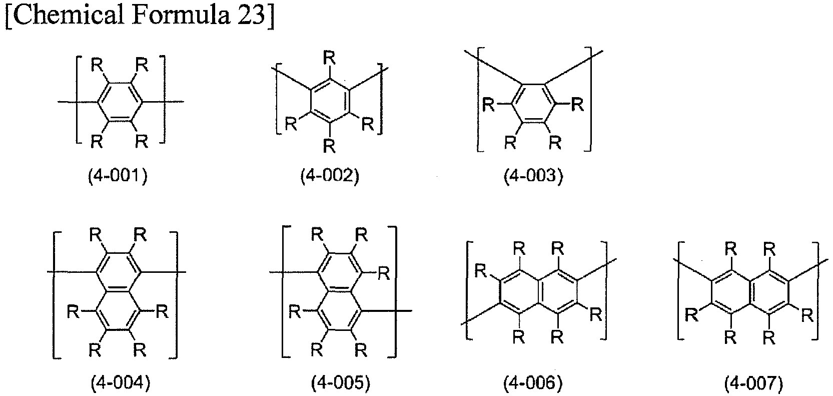 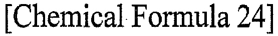 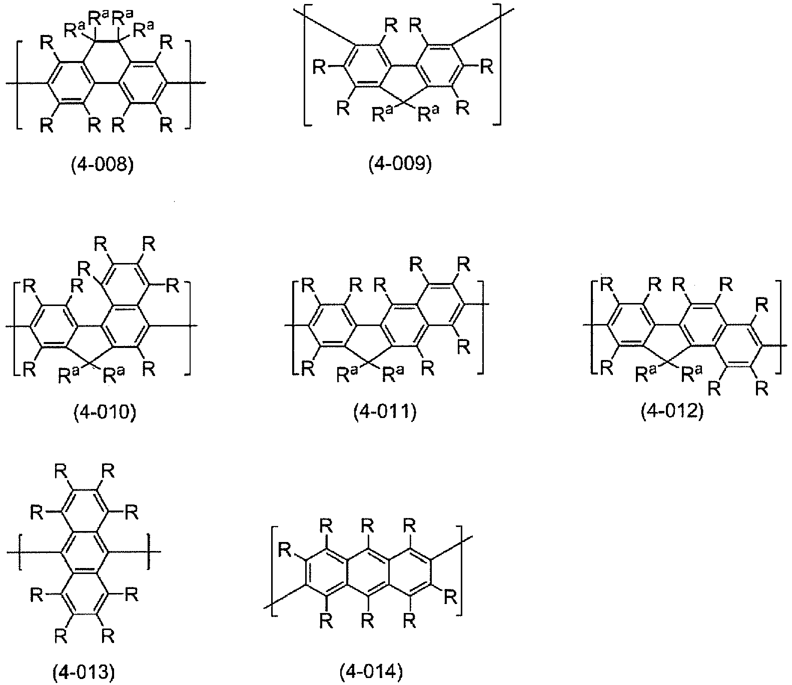 In the formulas, R represents a hydrogen atom or a group from among substituent group X. R^{a} has the same definition as above. Multiple R groups may be the same or different, and multiple R^{a} groups may also be the same or different.

In formula (4), the divalent aromatic heterocyclic group represented by Ar³ is preferably a divalent fused aromatic heterocyclic group for satisfactory stability of the polymer compound of this embodiment. The divalent fused aromatic heterocyclic group has usually 6-60 and preferably 8-20 carbon atoms. The number of carbons of the substituents are not included in this number of carbon atoms. Such divalent fused aromatic heterocyclic groups include quinolinediyl groups such as quinoline-2,6-diyl (formula (4-101)); isoquinolinediyl groups such as isoquinoline-1,4-diyl (formula (4-102)); quinoxalinediyl groups such as quinoxaline-5,8-diyl (formula (4-103)); carbazolediyl groups such as carbazole-3,6-diyl (formula (4-104)) and carbazole-2,7-diyl (formula (4-105)); dibenzofurandiyl groups such as dibenzofuran-4,7-diyl (formula (4-106)) and dibenzofuran-3,8-diyl (formula (4-107)); dibenzothiophenediyl groups such as dibenzothiophene-4,7-diyl (formula (4-108)) and dibenzothiophene-3,8-diyl (formula (4-109)); dibenzosiloldiyl groups such as dibenzosilol-4,7-diyl (formula (4-110)) and dibenzosilol-3,8-diyl (formula (4-111)); phenoxazinediyl groups such as phenoxazine-3,7-diyl (formula (4-112)) and phenoxazine-2,8-diyl (formula (4-113)); phenothiazinediyl groups such as phenothiazine-3,7-diyl (formula (4-114)) and phenothiazine-2,8-diyl (formula (4-115)); dihydroacridinediyl groups such as dihydroacridine-2,7-diyl (formula (4-116)); and divalent groups represented by (formula (4-117)). For these divalent fused aromatic heterocyclic groups, R in the formulas represents a hydrogen atom or any group from among substituent group X. R^{a} has the same definition as above. Multiple R groups may be the same or different, and multiple R^{a} groups may also be the same or different. 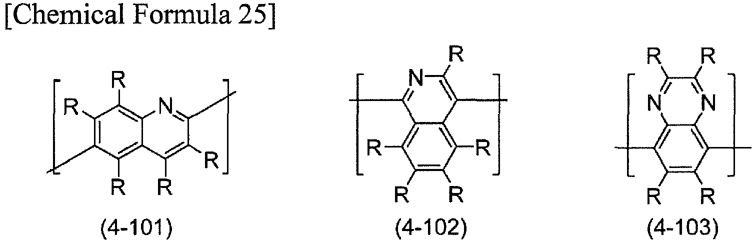 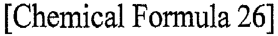 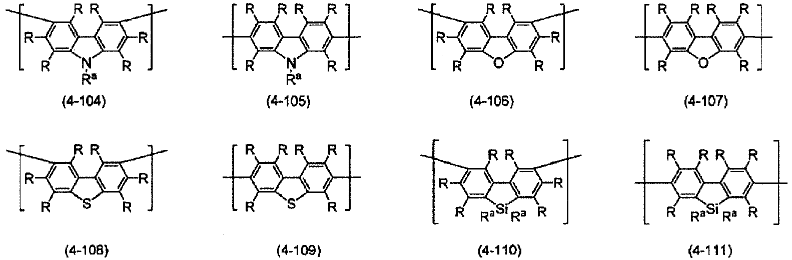 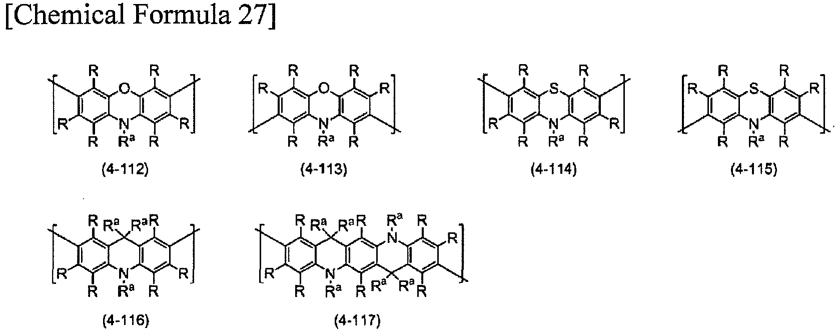 In formula (4), the "divalent group in which 2 or more of the same or different groups selected from the group consisting of arylene groups and divalent aromatic heterocyclic groups are linked" for Ar³ has usually 4-60 and preferably 12-60 carbon atoms. The number of carbons of the substituents are not included in this number of carbon atoms. Such groups include groups represented by the following formulas (4-201) to (4-208).

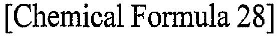

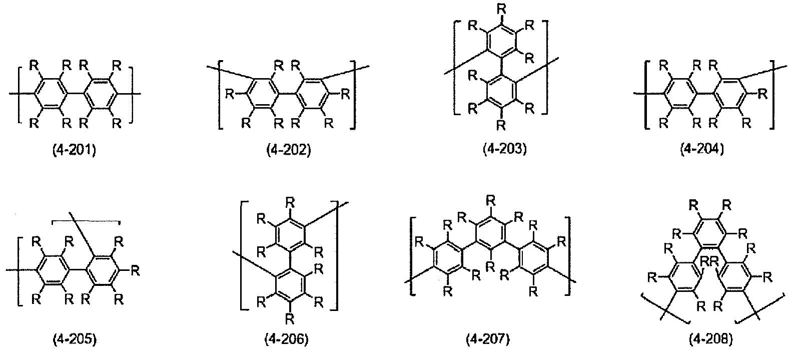

In the formulas, R has the same definition as above. When multiple R groups are present, they may be the same or different.

Ar³ is preferably 1,4-phenylene (formula (4-001)),1,3-phenylene (formula (4-002)), 9,10-dihydrophenanthrene-2,7-diyl (formula (4-008)), fluorene-3,6-diyl (formula (4-009)), a divalent group represented by (formula (4-010)), a divalent group represented by (formula (4-011)), a divalent group represented by (formula (4-012)), anthracene-2,6-diyl (formula (4-013)), anthracene-9,10-diyl (formula (4-014)), carbazole-3,6-diyl (formula (4-104)), carbazole-2,7-diyl (formula (4-105)), dibenzofuran-4,7-diyl (formula (4-106)), dibenzofuran-3,8-diyl (formula (4-107)), dibenzothiophene-4,7-diyl (formula (4-108)), dibenzothiophene-3,8-diyl (formula (4-109)), dibenzosilol-4,7-diyl (formula (4-110)), dibenzosilol-3,8-diyl (formula (4-111)), phenoxazine-3,7-diyl (formula (4-112)), phenothiazine-3,7-diyl (formula (4-114)), dihydroacridine-2,7-diyl (formula (4-116)), a divalent group represented by (formula (4-117)), a divalent group represented by (formula (4-201)), a divalent group represented by (formula (4-202)) or a divalent group represented by (formula (4-207)), for satisfactory stability of the polymer compound of this embodiment and more satisfactory light-emitting efficiency of light-emitting devices employing the polymer compound.

For satisfactory stability of the polymer compound of this embodiment and more satisfactory light-emitting efficiency of a light-emitting device employing the polymer compound, Ar³ is more preferably a group wherein R is a hydrogen atom, an alkyl group, an aryl group or a monovalent aromatic heterocyclic group, and more preferably R is a hydrogen atom or an alkyl group. Also, R^{a} is preferably an alkyl group or an aryl group.

The third constitutional unit may be a single type or two or more types in the polymer compound of this embodiment.

### [Fourth constitutional unit]

For even more satisfactory light-emitting efficiency of a light-emitting device employing the polymer compound, and of increasing the heat resistance, the polymer compound of this embodiment preferably comprises a constitutional unit represented by formula (5) (fourth constitutional unit). 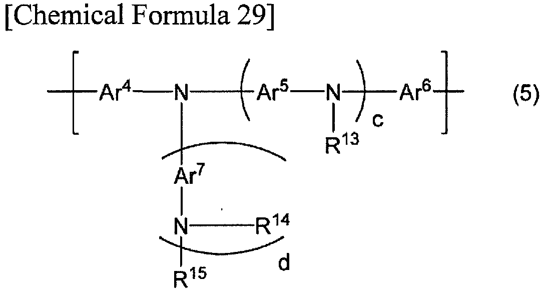 In formula (5), Ar⁴, Ar⁵, Ar⁶ and Ar⁷ each independently represent an optionally substituted arylene group, an optionally substituted divalent aromatic heterocyclic group, or an optionally substituted divalent group in which 2 or more arylene groups or divalent aromatic heterocyclic groups are linked. R¹³, R¹⁴ and R¹⁵ each independently represent a hydrogen atom, an alkyl group, an aryl group, a monovalent heterocyclic group or an arylalkyl group. c represents an integer of 0-3, and d represents 0 or 1.

In formula (5), the groups represented by Ar⁴, Ar⁵, Ar⁶ and Ar⁷ are preferably unsubstituted or substituted arylene groups, for satisfactory stability of the polymer compound of this embodiment and more excellent light-emitting efficiency of a light-emitting device employing the polymer compound.

In formula (5), the arylene groups for Ar⁴, Ar⁵, Ar⁶ and Ar⁷ may be the same as the groups represented by formula (1'-010) above and the constitutional unit represented by Ar³ mentioned above.

Also, the divalent aromatic heterocyclic groups for Ar⁴, Ar⁵, Ar⁶ and Ar⁷ in formula (5) include any of the same divalent aromatic heterocyclic groups for Ar³ mentioned above.

Examples for the "optionally substituted divalent group in which 2 or more arylene groups or divalent aromatic heterocyclic groups are linked" for Ar⁴, Ar⁵, Ar⁶ and Ar⁷ in formula (5) include the groups of formula (4) above which are represented by formulas (4-201) to (4-208). Ar⁴, Ar⁵, Ar⁶ and Ar⁷ also include groups containing groups represented by formula (1'-010) above.

For satisfactory stability of the polymer compound of this embodiment and more satisfactory light-emitting efficiency of a light-emitting device employing the polymer compound, R¹³, R¹⁴ and R¹⁵ in formula (5) are preferably alkyl groups, aryl groups or monovalent aromatic heterocyclic groups, and more preferably they are aryl groups.

Of the groups represented by Ar⁴, Ar⁵, Ar⁶ and Ar⁷ in formula (5), groups bonded to the same nitrogen atom may be bonded by single bonds, or by groups represented by -O-, -S-, -C(=O)-, -C(=O)-O-, -N(R^{A})-, -C(=O)-N(R^{A}) or -C(R^{A})(R^{A})-. This will normally form 5- to 7-membered rings.

Preferred as constitutional units represented by formula (5) are constitutional units represented by the following formulas (5-001) to (5-005). In the formulas, R and R^{a} have the same definitions as above.

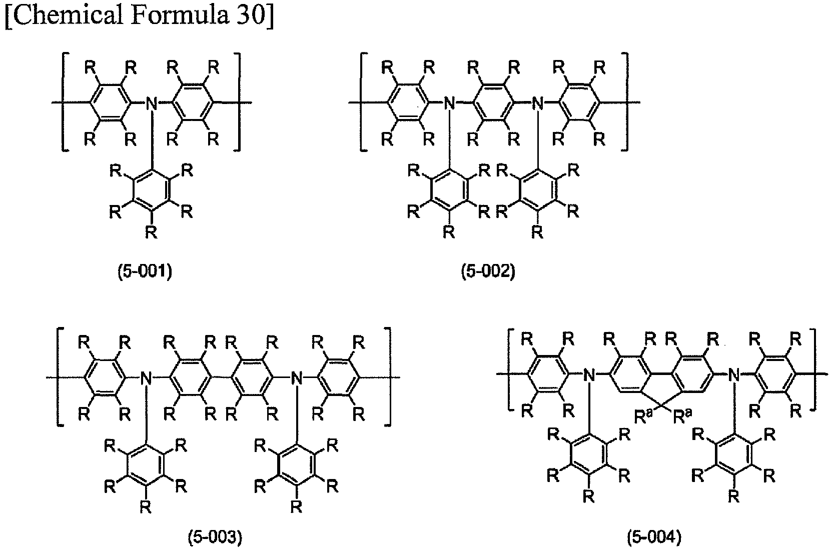

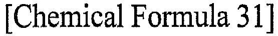

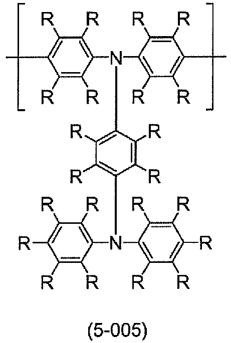

For satisfactory stability of the polymer compound of this embodiment and even more satisfactory light-emitting efficiency for a light-emitting device employing the polymer compound, the constitutional unit represented by formula (5) is preferably one wherein each R in formulas (5-001) to (5-005) is a hydrogen atom, an alkyl group, an aryl group or a monovalent aromatic heterocyclic group, and more preferably a hydrogen atom or an alkyl group. R^{a} in formulas (5-001) to (5-005) is preferably an alkyl group or an aryl group.

The fourth constitutional unit may be a single type or two or more types in the polymer compound of this embodiment.

### [Substituents]

The group represented by -S-R^{A} may be straight-chain, branched or cyclic, and may be an alkylthio group of usually 1-20 carbon atoms or an arylthio group of usually 6-60 carbon atoms.

The group represented by -C(=O)-R^{A} may be straight-chain, branched or cyclic, and may be an alkylcarbonyl group of usually 1-20 carbon atoms or an arylcarbonyl group of usually 6-60 carbon atoms.

The group represented by -C(=O)-O-R^{A} may be straight-chain, branched or cyclic, and may be an alkyloxycarbonyl group of usually 1-20 carbon atoms or an aryloxycarbonyl group of usually 6-60 carbon atoms.

The group represented by -N(R^{A})₂ may be an amino group substituted with 2 groups selected from the group consisting of alkyl groups with usually 1-20 carbon atoms and aryl groups with usually 6-60 carbon atoms.

[Constitutional chain of polymer compound of this embodiment] For more satisfactory light-emitting efficiency for a light-emitting device obtained using the polymer compound, the polymer compound of this embodiment preferably comprises a constitutional chain in which a constitutional unit represented by formula (1-1) and/or formula (2-1) and a constitutional unit represented by formula (3) are directly bonded.

The polymer compound is preferably a conjugated polymer compound, because when it is used for fabrication of a light-emitting device, the light-emitting efficiency of the obtained light-emitting device will be more excellent. The term "conjugated polymer compound" refers to a polymer compound in which a conjugated system extends along the main chain backbone, and examples include polyarylenes with arylene groups as constitutional units, such as polyfluorene and polyphenylene; polyheteroarylenes with divalent hetero aromatic groups as constitutional units, such as polythiophene and polydibenzofuran; polyarylenevinylenes such as polyphenylenevinylene, and copolymers with combinations of these constitutional units. The compound need only have essentially continuous conjugation even if a heteroatom is included in the constitutional unit in the main chain, and it may contain a constitutional unit derived from triphenylamine as the constitutional unit.

For even more satisfactory light-emitting efficiency for light-emitting devices obtained using the polymer compound, the polymer compound of this embodiment preferably has a total content for the first constitutional unit represented by formula (1-1) and/or (2-1), of preferably 0.01-90 mol%, more preferably 0.1-50 mol%, even more preferably 0.1-20 mol% and most preferably 0.1-10 mol%, based on the total content of the first constitutional unit, second constitutional unit, third constitutional unit and fourth constitutional unit.

For more excellent light-emitting efficiency for a light-emitting device obtained when the polymer compound of this embodiment is used to fabricate a light-emitting device, it has a total content for the first constitutional unit represented by formula (1-1) and/or formula (2-1), the second constitutional unit represented by formula (3), the third constitutional unit represented by formula (4) and the fourth constitutional unit represented by formula (5), of preferably 80 wt% or greater and more preferably 90 wt% or greater based on the total weight of the polymer compound.

When the polymer compound of this embodiment contains a fourth constitutional unit represented by formula (5), the content of the fourth constitutional unit is preferably 0.5 mol% or greater and more preferably 1 mol% or greater, based on the total content of the first constitutional unit, second constitutional unit, third constitutional unit and fourth constitutional unit. This content is also preferably no greater than 20 mol% and more preferably no greater than 10 mol%, to obtain more excellent light-emitting efficiency for a light-emitting device obtained when the polymer compound is used to fabricate a light-emitting device.

The polymer compound of this embodiment may be, for example, any of polymer compounds P1 to P21, having the first constitutional unit as an essential unit, combined with at least one type of constitutional unit from among the second constitutional unit, third constitutional unit and fourth constitutional unit. The total content of the first constitutional unit, the second constitutional unit, the third constitutional unit and the fourth constitutional unit in polymer compounds P1 to P21 is 100 wt%, based on the total polymer compound weight. Compounds P5, P6, P9 to P 14 and P 18 are forms where the first constitutional unit and third constitutional unit are bonded.

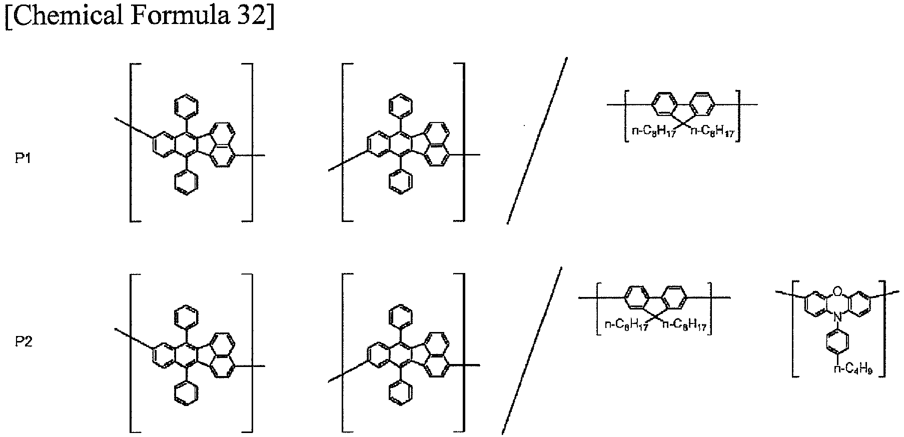

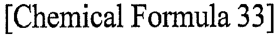

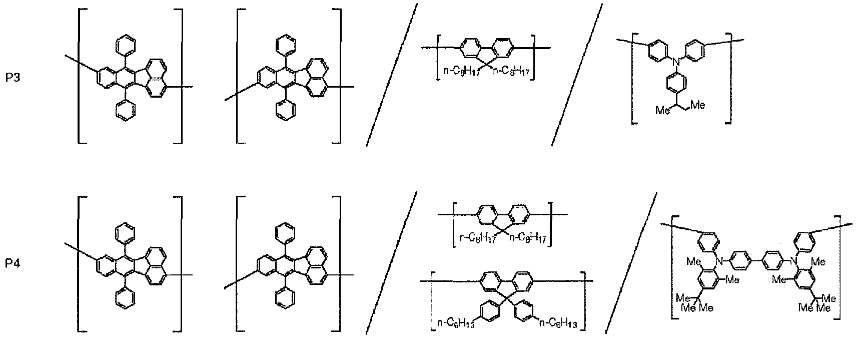

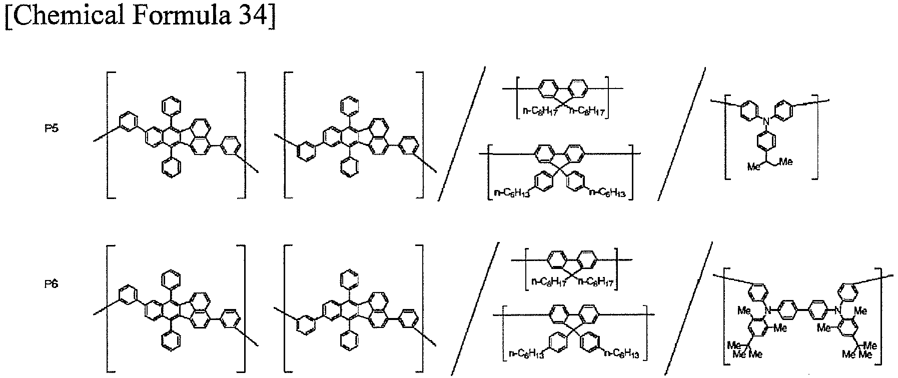

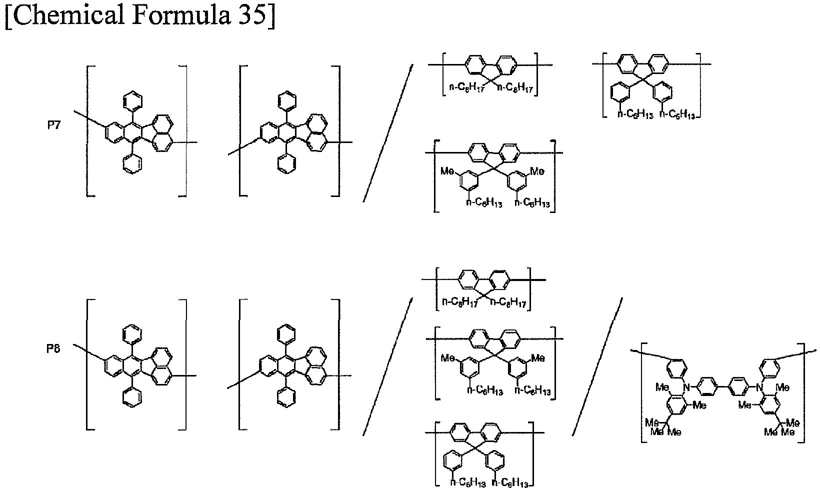

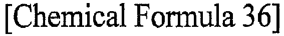

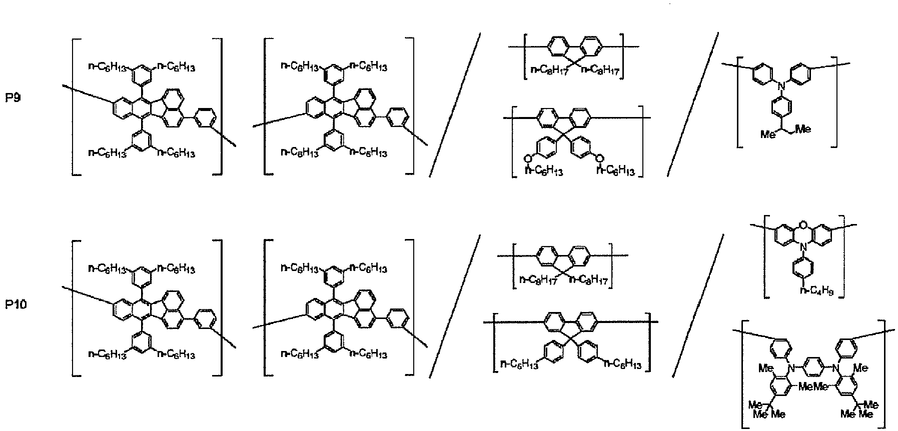

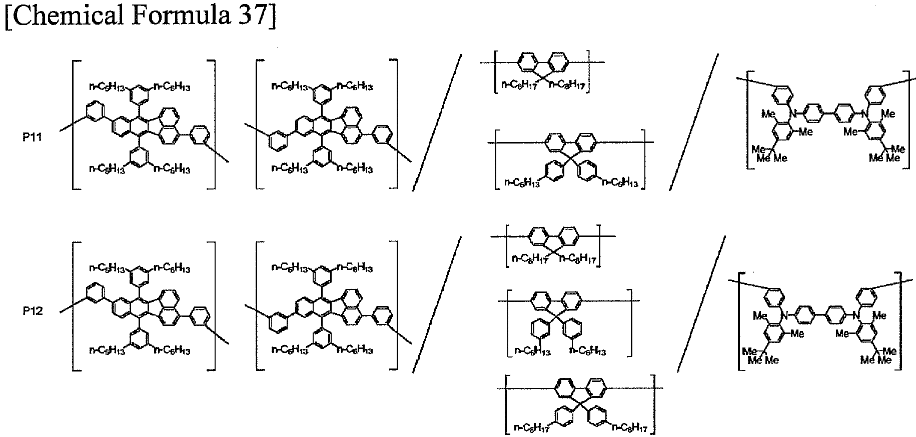

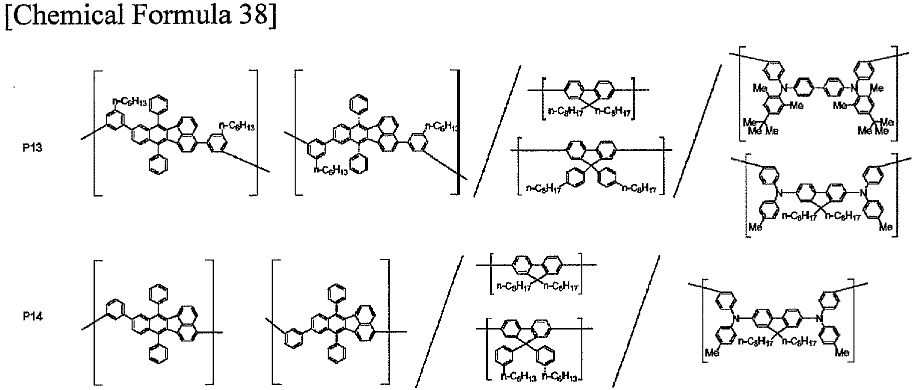

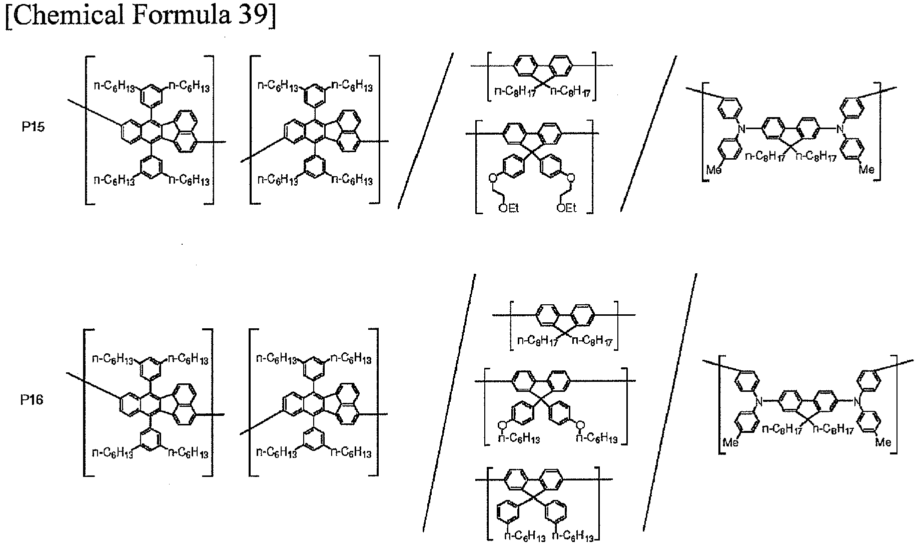

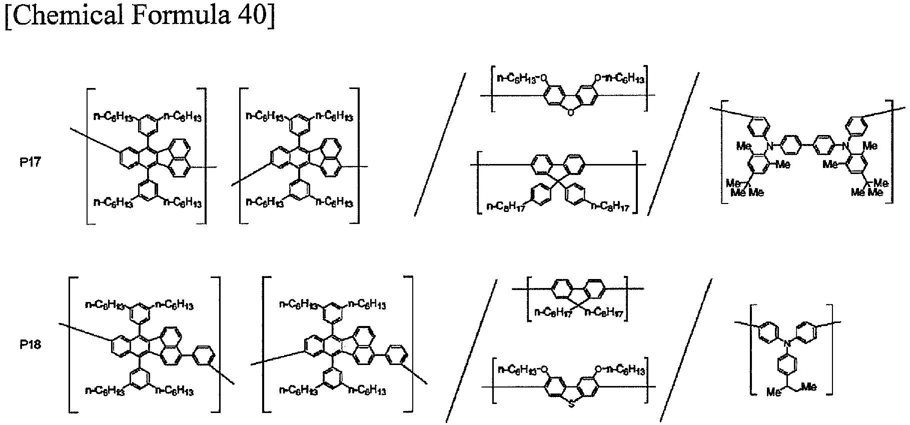

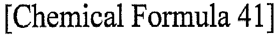

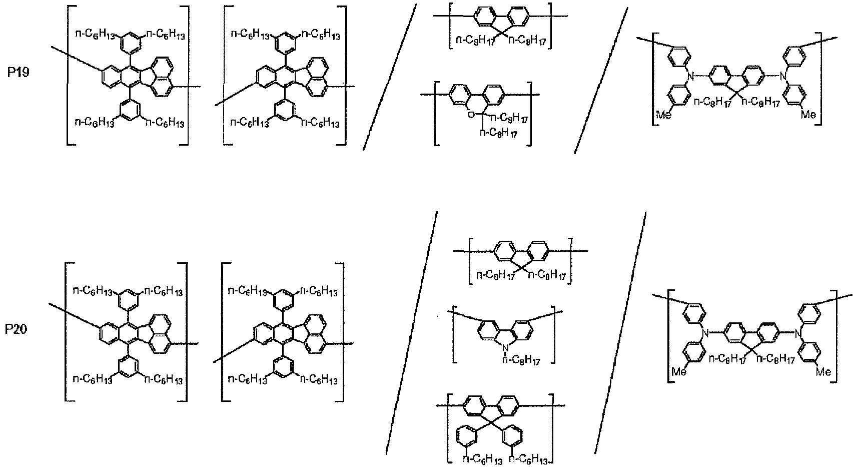

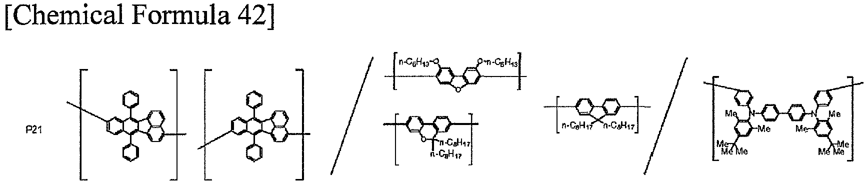

When polymerizable groups remain on the end groups in the polymer compound of this embodiment, the luminescence property and usable life of the light-emitting device may potentially be reduced when the polymer compound is used. The end groups are therefore preferably stable groups (for example, aryl groups or monovalent aromatic heterocyclic groups).

The polymer compound of this embodiment may be any copolymer, such as a block copolymer, random copolymer, alternating copolymer or graft copolymer.

The polymer compound of this embodiment is useful as a light-emitting material, charge transport material or the like, and when used it may be used in combination with other compounds as the polymer composition described below.

The polystyrene-equivalent number-average molecular weight (Mn) of the polymer compound of this embodiment, as measured by gel permeation chromatography (hereinafter, "GPC") will usually be 1 × 10³ to 1 × 10⁸ and is preferably 1 × 10⁴ to 1 × 10⁶. The polystyrene-equivalent weight-average molecular weight (Mw) of the polymer compound of this embodiment will usually be 1 × 10³ to 1 × 10⁸, and from the viewpoint of satisfactory film formability and more satisfactory light-emitting efficiency of light-emitting devices obtained from the polymer compound, it is preferably 1 × 10⁴ to 5 × 10⁶.

From the viewpoint of durability in various processes for fabrication of light-emitting devices and the like, and more satisfactory stability and heat resistance against heat release during operation of light-emitting devices, the glass transition temperature of the polymer compound of this embodiment is preferably 70°C or higher.

A light-emitting device employing a polymer compound of this embodiment is a high-performance light-emitting device capable of driving with high light-emitting efficiency. Consequently, the light-emitting device is useful for a backlight of display device, curved or flat light source for illumination, segment type display device, dot matrix flat panel display, or the like. In addition, the polymer compound of this embodiment may be used as a laser pigment, an organic solar cell material, an organic semiconductor for an organic transistor, a material for a conductive film such as an electric conductive film or organic semiconductor film, or a light-emitting film material that emits fluorescence or phosphorescence.

### <Method for producing polymer compound>

The polymer compound of this embodiment can be produced, for example, from a monomer composition comprising a compound represented by the following formula (6) and/or formula (7) (first monomer) and a compound represented by the following formula (3M) (second monomer). The polymer compound of this embodiment can be produced by dissolving the monomer composition in an organic solvent as necessary, and conducting copolymerization by a polymerization method such as known aryl-aryl coupling using an alkali or suitable catalyst, and a ligand. 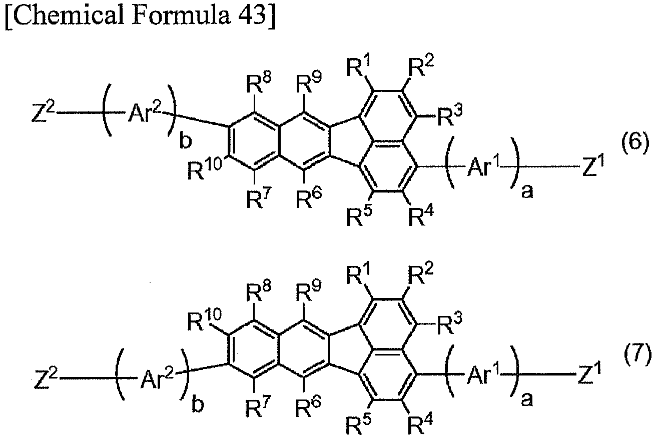 In formula (6) and formula (7), R¹-R¹⁰ have the same respective definitions as above, Ar¹ and Ar² each independently represent an optionally substituted arylene group or an optionally substituted divalent aromatic heterocyclic group, and a and b each independently represent 0 or 1. Z¹ and Z² each independently represent substituent group A or substituent group B. Here, "substituent group A" consists of a chlorine atom, a bromine atom, an iodine atom and groups represented by -O-S(=O)₂R¹⁶ (where R¹⁶ represents an optionally substituted alkyl group, or an aryl group optionally substituted with an alkyl group, an alkoxy group, a nitro group, a fluorine atom or a cyano group). "Substituent group B" consists of groups represented by -B(OR¹⁷)₂ (where R¹⁷ represents a hydrogen atom or an alkyl group, and the two R¹⁷ groups may be the same or different and may be bonded together to form a ring), groups represented by -BF₄Q¹ (where Q¹ represents a monovalent cation of lithium, sodium, potassium, rubidium or cesium), groups represented by -MgY¹ (where Y¹ represents a chlorine atom, a bromine atom or iodine atom), groups represented by -ZnY² (where Y² represents a chlorine atom, a bromine atom or an iodine atom) and groups represented by -Sn(R¹⁸)₃ (where R¹⁸ represents a hydrogen atom or an alkyl group, and the three R¹⁸ groups may be the same or different and may be bonded together to form a ring).

The alkyl groups for R¹⁶, R¹⁷ and R¹⁸ may be methyl, ethyl, propyl, isopropyl, butyl, sec-butyl, isobutyl, pentyl, 2-methylbutyl, isoamyl, hexyl, heptyl, octyl, 2-ethylhexyl, nonyl, decyl, 3,7-dimethyloctyl, dodecyl or the like, which groups may be optionally substituted. The number of carbon atoms of each of the alkyl groups will usually be 1-20, preferably 1-15 and more preferably 1-10.

Examples of aryl groups for R¹⁶ include the same aryl groups for R¹ in formula (1-1), but for ease of synthesizing the polymer compound and satisfactory reactivity during polymerization, phenyl, 4-tolyl, 4-methoxyphenyl, 4-nitrophenyl, 3-nitrophenyl, 2-nitrophenyl and 4-trifluoromethylphenyl groups are preferred.

Groups represented by -O-S(=O)₂R¹⁶ include methanesulfonyloxy, trifluoromethanesulfonyloxy, phenylsulfonyloxy, 4-methylphenylsulfonyloxy and 4-trifluoromethylphenylsulfonyloxy.

Groups represented by -B(OR¹⁷)₂ include groups represented by the following formula.

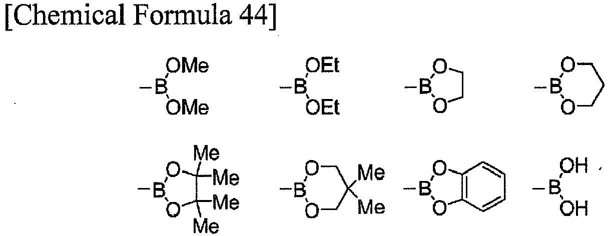

Groups represented by -BF₄Q¹ include groups represented by -BF₄⁻K⁺, for example.

Groups represented by -Sn(R¹⁸)₃ include trimethylstannyl, triethylstannyl and tributylstannyl. 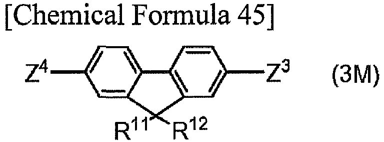 In formula (3M), R¹¹ and R¹² are as defined above. Also, Z³ and Z⁴ each independently represent a group selected from the group consisting of substituent group A and substituent group B. When Z¹ and Z² in formula (6) and/or formula (7) are both groups selected from among substituent group A, at least one of Z³ and Z⁴ is a group selected from among substituent group B. When Z¹ and Z² in formula (6) and/or formula (7) are both groups selected from among substituent group B, at least one of Z³ and Z⁴ is preferably a group selected from among substituent group A.

For production of a polymer compound of this embodiment, the monomer composition preferably further comprises a compound represented by the following formula (4M) (third monomer) and/or a compound represented by the following formula (5M) (fourth monomer).

[Chemical Formula 46] Z⁶-Ar³-Z⁵ (4M)

In formula (4M), Ar³ has the same definition as Ar³ in formula (4), and Z⁵ and Z⁶ each independently represent a group selected from the group consisting of substituent group A and substituent group B. 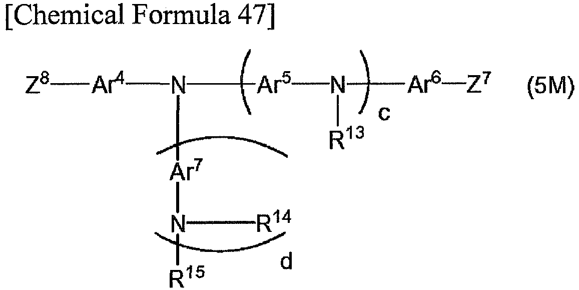 In formula (5M), Ar⁴, Ar⁵, Ar⁶, Ar⁷, R¹³, R¹⁴, R¹⁵, c and d have the same respective definitions as Ar⁴, Ar⁵ Ar⁶, Ar⁷, R¹³, R¹⁴, R¹⁵, c and d in formula (5), and Z⁷ and Z⁸ each independently represent a group selected from the group consisting of substituent group A and substituent group B.

A mixture of a monomer of formula (6) and a monomer of formula (7) may also be used in the method for producing a polymer compound of this embodiment, with no restrictions on the mixing ratio.

The first monomer, second monomer, third monomer and fourth monomer may be synthesized and isolated beforehand, or they may be synthesized in the reaction system and used directly. When the obtained polymer compound is to be used in a light-emitting device, its purity will affect the performance of the light-emitting device. Therefore, these monomers are preferably purified by a method such as distillation, sublimation purification or recrystallization.

The polymerization method may be a method of polymerization by Suzuki coupling reaction (Chem. Rev. Vol.95, p.2457-2483(1995)), a method of polymerization by Grignard reaction (Bull. Chem. Soc. Jpn., Vol.51, p.2091(1978)), a method of polymerization with a Ni(0) catalyst (Progress in Polymer Science, Vol.17, p.1153-1205, 1992), or a method of polymerization by Stille coupling reaction (European Polymer Journal Vol.41, p.2923-2933(2005)). Of these methods, polymerization by Suzuki coupling reaction and polymerization with a Ni(0) catalyst are preferred from the viewpoint of ease of starting material synthesis and convenience of the polymerization reaction procedure, while from the viewpoint of easier control of the polymer compound structure, methods of polymerization by aryl-aryl cross-coupling reaction such as Suzuki coupling reaction, Grignard reaction or Stille coupling reaction are preferred, and polymerization reaction by Suzuki coupling reaction is especially preferred.

The group selected from the group consisting of substituent group A and substituent group B may be selected as a group which is appropriate for the type of polymerization reaction, and when a method of polymerization by Suzuki coupling reaction is employed, the group selected from among substituent group A is preferably a chlorine atom, a bromine atom or an iodine atom, and more preferably a bromine atom, and the group selected from among substituent group B is preferably a group represented by -B(OR¹⁷)₂, from the viewpoint of convenience of synthesis and ease of handling the compounds.

The polymerization method may be a method of reacting the first monomer, the second monomer, and the third monomer and/or fourth monomer, with an appropriate catalyst or base as necessary. When a method of polymerization by Suzuki coupling reaction is selected, the ratio of the total number of moles of the group selected from among substituent group A (for example, a chlorine atom, an iodine atom or a bromine atom), and the total number of moles of the group selected from among substituent group B (for example, -B(OR¹⁷)₂) in the first monomer, second monomer, third monomer and fourth monomer is preferably adjusted to obtain a polymer compound with the desired molecular weight. For most purposes, the ratio of the number of moles of the latter with respect to the number of moles of the former is preferably 0.95-1.05, more preferably 0.98-1.02 and even more preferably 0.99-1.01.

In the method for producing a polymer compound of this embodiment, the charging ratio of the compound represented by formula (6) with respect to the total monomers is preferably 0.1 mol% or greater and no greater than 20 mol%. This will allow easy production of a polymer compound in which the proportion of the first constitutional unit represented by formula (1-1) and/or formula (2-1) with respect to the total constitutional units is between 0.1 mol% and 20 mol%.

One preferred embodiment of the polymer compound of this embodiment is a polymer compound containing a constitutional chain in which a first constitutional unit and second constitutional unit are linked. This method for producing a polymer compound may be a method which is polymerization employing aryl-aryl cross-coupling reaction, wherein polymerizable groups corresponding to the monomers (first monomer and second monomer) are selected so that the first constitutional unit and second constitutional unit can be directly bonded, or a method using compounds of formula (6) and/or formula (7) having groups represented by formula (3) as Ar¹ and Ar².

Specifically, for polymerization by Suzuki coupling reaction, preferably the first monomer is a compound in which Z¹ and Z² in formula (6) and/or formula (7) are groups represented by -B(OR¹⁷)₂ or groups represented by -BF₄Q¹, and the second monomer is a compound in which Z³ and Z⁴ in formula (3M) is a chlorine atom, a bromine atom or an iodine atom. Similarly, preferably the first monomer is a compound in which Z¹ and Z² in formula (6) are a chlorine atom, a bromine atom or an iodine atom, and the second monomer is a compound wherein Z³ and Z⁴ are groups represented by -B(OR¹⁷)₂ or groups represented by -BF₄Q¹.
Using such monomers will result in direct bonding between the first constitutional unit and second constitutional unit since the Suzuki coupling reaction will be a cross-coupling reaction.

In the method for producing a polymer compound of this embodiment, the monomers are preferably polymerized in the presence of a catalyst. For polymerization by Suzuki coupling reaction, the catalyst may be a transition metal complex, for example, a palladium complex such as palladium [tetrakis(triphenylphosphine)], [tris(dibenzylideneacetone)]dipalladium, palladium acetate or dichlorobistriphenylphosphinepalladium, or a complex in which a ligand such as triphenylphosphine, tri-tert-butylphosphine or tricyclohexylphosphine is coordinated with these transition metal complexes.

For polymerization with a Ni(0) catalyst, the Ni(0) catalyst may be a transition metal complex, for example a nickel complex such as nickel [tetrakis(triphenylphosphine)], [1,3-bis(diphenylphosphino)propane]dichloronickel or [bis(1,4-cyclooctadiene)]nickel, or a complex in which a ligand such as triphenylphosphine, tri-*tert*-butylphosphine, tricyclohexylphosphine, diphenylphosphinopropane or bipyridyl is coordinated with these transition metal complexes.

The catalyst may be synthesized beforehand or prepared in the reaction system and used directly. These catalysts may be used alone or in combinations of two or more.

The amount of catalyst used may be an amount that is effective as a catalyst, and for example, it will usually be 0.0001-300 mol%, preferably 0.001-50 mol% and more preferably 0.01-20 mol%, in terms of the number of moles of the transition metal with respect to 100 mol% as the total of all of the monomers in the polymerization reaction.

For polymerization by Suzuki coupling reaction it is preferred to use a base, with bases including inorganic bases such as sodium carbonate, potassium carbonate, cesium carbonate, potassium fluoride, cesium fluoride and tripotassium phosphate, and organic bases such as tetrabutylammonium fluoride, tetrabutylammonium chloride, tetrabutylammonium bromide, tetraethylammonium hydroxide and tetrabutylammonium hydroxide.

The amount of base used will usually be 50-2000 mol% and preferably 100-1000 mol% with respect to 100 mol% as the total of all of the monomers in the polymerization reaction.

The polymerization reaction may be carried out in the absence of a solvent or in the presence of a solvent, but it will usually be carried out in the presence of an organic solvent. The organic solvent may be toluene, xylene, mesitylene, tetrahydrofuran, 1,4-dioxane, dimethoxyethane, N,N-dimethylacetamide, N,N-dimethylformamide or the like. In order to minimize secondary reactions, the solvent is generally preferred to be one that has been subjected to deoxidizing treatment. Such organic solvents may be used alone or in combinations of two or more.

The amount of organic solvent used is preferably an amount for a total concentration of 0.1-90 wt%, more preferably 1-50 wt% and even more preferably 2-30 wt% for the total monomers in the polymerization reaction.

The reaction temperature for the polymerization reaction is preferably between -100 and 200°C, more preferably between -80 and 150°C and even more preferably between 0 and 120°C. The reaction time will usually be at least 1 hour, and is preferably 2-500 hours.

When a monomer with a group represented by -MgY¹ is to be used as Z¹ or Z² in the method for producing a polymer compound of this embodiment, the polymerization reaction is preferably carried out under dehydrating conditions. On the other hand, when the polymerization reaction is a Suzuki coupling reaction, the base may be used as an aqueous solution, and water may be added to the aforementioned organic solvent, for use as the solvent.

In order to prevent polymerizable groups (such as Z¹ and Z²) from remaining at the ends of the polymer compound of this embodiment in the polymerization reaction, a compound represented by the following formula (11) may be used as a chain terminator. This will allow a polymer compound to be obtained in which the ends are aryl or monovalent aromatic heterocyclic groups.

[Chemical Formula 48] Z⁹-Ar⁸ (11)

In the formula, Ar⁸ represents an optionally substituted aryl group or an optionally substituted monovalent aromatic heterocyclic group, and Z⁹ represents a group selected from the group consisting of substituent group A and substituent group B. The aryl and monovalent aromatic heterocyclic groups for Ar⁸ may be any of the same as the aryl and monovalent aromatic heterocyclic groups mentioned for R¹ above.

Post-treatment after polymerization reaction may be carried out by a known method, such as adding the reaction solution obtained by polymerization reaction to a lower alcohol such as methanol and filtering and drying the deposited precipitate.

When the purity of the polymer compound of this embodiment is low, it may be purified by a common method such as recrystallization, reprecipitation, continuous extraction with a Soxhlet extractor or chromatography (for example, column chromatography), but when the polymer compound of this embodiment is to be used in a light-emitting device, the purity may affect the performance of the element, including its luminescence property, and therefore the condensation polymerization is preferably followed by purification treatment, such as reprecipitation or fractionation by chromatography.

### <Monomer production method>

A method for producing a compound represented by formula (6) and/or formula (7) (i.e. monomer), to be used for production of a polymer compound of this embodiment, will now be described. The method for producing a compound represented by formula (6) and/or formula (7) may be represented by the following reaction scheme (R1), and synthesis may be carried out by reacting a compound represented by formula (8) and/or formula (9), having one polymerizable group Z², with a compound represented by formula (10), having one polymerizable group Z¹. 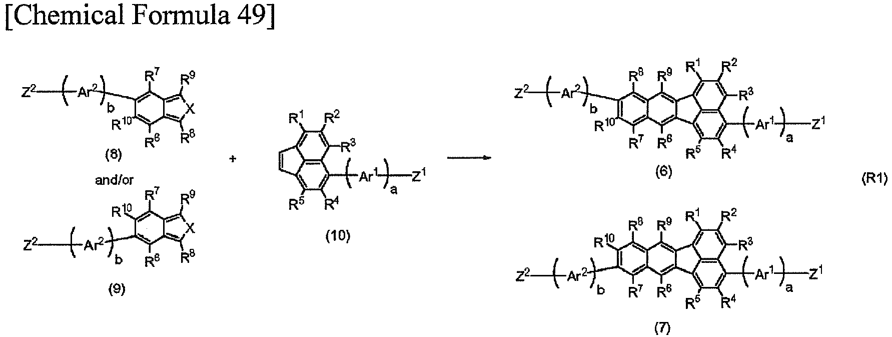 In reaction scheme (R1), R¹-R¹⁰, Ar¹, Ar², a, b, Z¹ and Z² have the same respective defmitions as above. X represents an oxygen atom or a carbonyl group.

In formula (8) and/or formula (9), X is preferably an oxygen atom.

A compound represented by formula (8) and/or formula (9) wherein X is an oxygen atom may be synthesized by the synthesis method described in Synlett 2006, No. 13, 2035 or Org. Lett., 2008, 10, 3757, for example. A compound represented by formula (10) may be synthesized by the synthesis method described in Can. J. Chem. 1992, Vol.70, 1015, for example.

A monomer represented by formula (6) and/or formula (7) may be synthesized by reaction according to the method described in J. Am. Chem. Soc., 1952, Vol.73, 1075., for example, using compounds represented by formula (8) and/or formula (9) and formula (10).

Z¹ and Z² are preferably a chlorine atom, a bromine atom or an iodine atom as this will facilitate production of the monomer.

In reaction scheme (R1), a compound wherein Z¹ and Z² is a chlorine atom, a bromine atom or an iodine atom can be converted to a boric acid derivative, which is useful for polymerization by Suzuki coupling reaction, according to the method described in Journal of Synthetic Organic Chemistry, Japan, 1999, Vol.57, 503, for example. Also, for a boric acid derivative, a boric acid-derived group can be converted to a group represented by the following formula (13) by selective Suzuki coupling reaction (for example, the method described in Org. Lett., 2005, Vol.7, 4229) using an iodobrominated compound represented by the following formula (12).

[Chemical Formula 50] I-Ar-Br (12)

In formula (12), Ar represents an optionally substituted arylene group or an optionally substituted divalent aromatic heterocyclic group, or an optionally substituted divalent group in which two or more arylene groups or divalent aromatic heterocyclic groups are linked.

[Chemical Formula 51] -Ar-Br (13)

In formula (13), Ar has the same definition as above.

These compounds can be purified by common methods such as recrystallization, reprecipitation, continuous extraction with a Soxhlet extractor, activated carbon treatment or column chromatography.

### <Polymer composition>

The polymer composition of this embodiment comprises a polymer compound, and at least one material selected from the group consisting of hole transport materials, electron transport materials and light-emitting materials.

Examples of hole transport materials include polyvinylcarbazole and its derivatives, polysilane and its derivatives, polysiloxane derivatives having aromatic amines on side chains or the main chain, pyrazoline derivatives, arylamine derivatives, stilbene derivatives, polyaniline and its derivatives, polythiophene and its derivatives, polypyrrole and its derivatives, poly(p-phenylenevinylene) and its derivatives and poly(2,5-thienylenevinylene) and its derivatives. Additional ones include those mentioned in Japanese Unexamined Patent Application Publication SHO No. 63-70257, Japanese Unexamined Patent Application Publication SHO No. 63-175860, Japanese Unexamined Patent Application Publication HEI No. 2-135359, Japanese Unexamined Patent Application Publication HEI No. 2-135361, Japanese Unexamined Patent Application Publication HEI No. 2-209988, Japanese Unexamined Patent Application Publication HEI No. 3-37992 and Japanese Unexamined Patent Application Publication HEI No. 3-152184.

The content of a hole transport material is preferably 1-500 parts by weight and more preferably 5-200 parts by weight with respect to 100 parts by weight of the polymer compound in the polymer composition.

Electron transport materials include oxadiazole derivatives, quinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives and polyfluorene and its derivatives. Additional ones include those mentioned in Japanese Unexamined Patent Application Publication SHO No. 63-70257, Japanese Unexamined Patent Application Publication SHO No. 63-175860, Japanese Unexamined Patent Application Publication HEI No. 2-135359, Japanese Unexamined Patent Application Publication HEI No. 2-135361, Japanese Unexamined Patent Application Publication HEI No. 2-209988, Japanese Unexamined Patent Application Publication HEI No. 3-37992 and Japanese Unexamined Patent Application Publication HEI No. 3-152184.

The content of an electron transport material is preferably 1-500 parts by weight and more preferably 5-200 parts by weight with respect to 100 parts by weight of the polymer compound in the polymer composition.

The light-emitting material may be a low molecular fluorescent material, a phosphorescent light-emitting material, or the like. Specific examples include naphthalene derivatives, anthracene and its derivatives, perylene and its derivatives, pigments such as polymethine-based pigments, xanthene-based pigments, coumarin-based pigments and cyanine-based pigments, metal complexes with 8-hydroxyquinoline as a ligand, metal complexes with 8-hydroxyquinoline derivatives as ligands, other fluorescent metal complexes, aromatic amines, tetraphenylcyclopentadiene and its derivatives, tetraphenylbutadiene and its derivatives, low molecular compound fluorescent materials such as stilbene-based, silicon-containing aromatic, oxazole-based, furoxan-based, thiazole-based, tetraarylmethane-based, thiadiazole-based, pyrazole-based, metacyclophane-based and acetylene-based compounds, metal complexes such as iridium complexes and platinum complexes, triplet emitting complexes, and the like. They also include the compounds mentioned in Japanese Unexamined Patent Application Publication SHO No. 57-51781 and Japanese Unexamined Patent Application Publication SHO No. 59-194393.

The content of a light-emitting material is preferably 1-500 parts by weight and more preferably 5-200 parts by weight with respect to 100 parts by weight of the polymer compound in the polymer composition. Preferred as such light-emitting materials are light-emitting materials according to this embodiment.

### <Solution>

The polymer compound of this embodiment may be dissolved or dispersed in an organic solvent to form a solution or dispersion (hereunder referred to simply as "solution"). Such a solution or dispersion is known as an ink or liquid composition. The solution may comprise a polymer compound and at least one material selected from the group consisting of hole transport materials, electron transport materials and light-emitting materials.

The organic solvent may be a chlorine-based solvent such as chloroform, methylene chloride, 1,2-dichloroethane, 1,1,2-trichloroethane, chlorobenzene or o-dichlorobenzene; an ether-based solvent such as tetrahydrofuran or dioxane; an aromatic hydrocarbon-based solvent such as toluene, xylene, trimethylbenzene or mesitylene; an aliphatic hydrocarbon-based solvent such as cyclohexane, methylcyclohexane, n-pentane, n-hexane, n-heptane, n-octane, n-nonane or n-decane; a ketone-based solvent such as acetone, methyl ethyl ketone or cyclohexanone; an ester-based solvent such as ethyl acetate, butyl acetate, methyl benzoate or ethyl cellosolve acetate; a polyhydric alcohol such as ethylene glycol, ethyleneglycol monobutyl ether, ethyleneglycol monoethyl ether, ethyleneglycol monomethyl ether, dimethoxyethane, propylene glycol, diethoxymethane, triethyleneglycol monoethyl ether, glycerin or 1,2-hexanediol, or a derivative thereof; an alcohol-based solvent such as methanol, ethanol, propanol, isopropanol or cyclohexanol; a sulfoxide-based solvent such as dimethyl sulfoxide; or an amide-based solvent such as N-methyl-2-pyrrolidone or N,N-dimethylformamide. These organic solvents may be used alone or in combinations of two or more. Preferred among these organic solvents, from the viewpoint of satisfactory viscosity and film formability, are those including organic solvents with a benzene ring-containing structure, having a melting point of no higher than 0°C and a boiling point of 100°C or higher.

Such solutions allow easy production of an organic film comprising a polymer compound of this embodiment. Specifically, the solution may be coated onto a substrate and heated, and subjected to pressure reduction and the like to remove the organic solvent, thereby obtaining an organic film comprising a polymer compound of this embodiment. The organic solvent may be removed by heating at about 50°C to 150°C and pressure reduction at about 10⁻³ Pa, varying the conditions as appropriate for the organic solvent used.

The coating may be accomplished using a coating method such as a spin coating method, a casting method, a microgravure method, a gravure coating method, a bar coating method, a roll coating method, a wire bar coating method, a dip coating method, a slit coating method, a capillary coating method, a spray coating method, a screen printing method, a flexographic printing method, an offset printing method, an ink jet printing method, a nozzle coating method or the like.

The preferred viscosity for the solution will differ depending on the printing method, but it is preferably 0.5-500 mPa·s at 25°C. When the solution is to be passed through a discharge device such as in an ink jet printing method, the viscosity at 25°C is preferably 0.5-20 mPa·s to prevent clogging or curving trajectory during discharge.

### <Organic film>

The organic film of this embodiment comprises a polymer compound of this embodiment. The organic film may comprise a polymer compound and at least one material selected from the group consisting of hole transport materials, electron transport materials and light-emitting materials. The organic film of this embodiment can be easily produced from the aforementioned solution, as described above.

The organic film of this embodiment can be suitably used as a light-emitting layer for an organic light-emitting device, described hereunder. It can also be suitably used in an organic semiconductor element. Because the organic film of this embodiment comprises the aforementioned polymer compound, when it is used as a light-emitting layer for a light-emitting device, the light-emitting device has very excellent light-emitting efficiency.

### <Light-emitting device>

A light-emitting device of this embodiment comprises the organic film described above.

Specifically, the light-emitting device of this embodiment comprises an anode, a cathode, and a layer containing the aforementioned polymer compound between the anode and cathode. The layer containing the polymer compound is preferably a layer composed of the aforementioned organic film, and the layer preferably functions as a light-emitting layer. When the layer containing the polymer compound is to function as a light-emitting layer, the following are preferred embodiments thereof.

The light-emitting device of this embodiment may have any of the following structures (a)-(d). The "/" separator indicates lamination of the previous and subsequent layers in an adjacent manner. (For example, "anode/light-emitting layer" indicates that the anode and light-emitting layer are laminated adjacently.)
(a) Anode/light-emitting layer/cathode
(b) Anode/hole transport layer/light-emitting layer/cathode
(c) Anode/light-emitting layer/electron transport layer/cathode
(d) Anode/hole transport layer/light-emitting layer/electron transport layer/cathode

A light-emitting layer is a layer having a light-emitting function, a hole transport layer is a layer having a function of transporting holes, and an electron transport layer is a layer having a function of transporting electrons. The hole transport layer and electron transport layer may collectively be referred to as "charge transport layers". Also, the hole transport layer adjacent to the light-emitting layer may be referred to as "interlayer".

The lamination and film formation for each layer may be accomplished using a solution comprising the constituent components for each layer. The lamination and film formation from the solution may be accomplished using a coating method such as a spin coating method, a casting method, a microgravure coating method, a gravure coating method, a bar coating method, a roll coating method, a wire bar coating method, a dip coating method, a slit coating method, a capillary coating method, a spray coating method, a screen printing method, a flexographic printing method, an offset printing method, an ink jet printing method, a nozzle coating method or the like.

The film thickness of the light-emitting layer may be selected for suitable values of the driving voltage and light-emitting efficiency, and for most cases it will be 1 nm to 1 µm, preferably 2 nm to 500 nm and more preferably 5 nm to 200 nm.

The hole transport layer preferably comprises the aforementioned hole transport material. Film formation of the hole transport layer may be accomplished by any method, but when the hole transport material is a polymer compound, the film formation is preferably from a solution containing the hole transport material, and when the hole transport material is a low molecular compound, the film formation is preferably from a mixed solution comprising a macromolecular binder and the hole transport material. The film-forming method employed may be the same method as the coating method described above.

The macromolecular binder is preferably one that produces minimal interference with charge transport, and one with weak absorption for visible light. Macromolecular binders include polycarbonates, polyacrylates, polymethyl acrylate, polymethyl methacrylate, polystyrene, polyvinyl chloride, polysiloxanes and the like.

The thickness of the hole transport layer may be selected for suitable values for the driving voltage and light-emitting efficiency, but since the thickness must be such that pinholes are not generated, it is usually 1 nm to 1 µm, preferably 2 nm to 500 nm, and even more preferably 5 nm to 200 nm.

The electron transport layer preferably comprises the aforementioned electron transport material. Film formation of the electron transport layer may be accomplished by any method, but when the electron transport material is a polymer compound, it is preferred to use a method of film formation from a solution comprising the electron transport material, or a method of film formation by melting of the electron transport material. When the electron transport material is a low molecular compound, it is preferred to use a method of film formation by vacuum vapor deposition using a powder of the electron transport material, a method of film formation from a solution comprising the electron transport material, or a method of film formation by melting of the electron transport material. An example of a method of film formation from a solution comprising the electron transport material is the same method as the coating method described above. The solution may also contain a macromolecular binder.

The macromolecular binder is preferably one that produces minimal interference with charge transport, and one with weak absorption for visible light. Macromolecular binders include poly(N-vinylcarbazole), polyaniline and its derivatives, polythiophene and its derivatives, poly(p-phenylenevinylene) and its derivatives, poly(2,5-thienylenevinylene) and its derivatives, polycarbonates, polyacrylates, polymethyl acrylates, polymethyl methacrylates, polystyrenes, polyvinyl chlorides, polysiloxanes and the like.

The thickness of the electron transport layer may be selected for suitable values for the driving voltage and light-emitting efficiency, but since the thickness must be such that pinholes are not generated, it is usually 1 nm to 1 µm, preferably 2 nm to 500 nm, and more preferably 5 nm to 200 nm.

Of the charge transport layers formed adjacent to the electrodes, those having the function of improving the charge injection efficiency from the electrodes and having an effect of lowering the driving voltage of the light-emitting device, are often referred to particularly as charge injection layers (hole injection layer, electron injection layer). In order to increase adhesiveness with the electrodes and improve charge injection from the electrodes, there may be provided adjacent to the electrodes a charge injection layer or insulating layer, while a thin buffer layer may be inserted at the interface with the charge transport layer or light-emitting layer to improve the interfacial adhesiveness and prevent intermixture. The order and number of the laminated layers and the thickness of each layer may be selected in consideration of the desired light-emitting efficiency and element lifespan.

Light-emitting devices with charge injection layers include those having the following structures (e)-(p).
(e) Anode/charge injection layer/light-emitting layer/cathode
(f) Anode/light-emitting layer/charge injection layer/cathode
(g) Anode/charge injection layer/light-emitting layer/charge injection layer/cathode
(h) Anode/charge injection layer/hole transport layer/light-emitting layer/cathode
(i) Anode/hole transport layer/light-emitting layer/charge injection layer/cathode
(j) Anode/charge injection layer/hole transport layer/light-emitting layer/charge injection layer/cathode
(k) Anode/charge injection layer/light-emitting layer/charge transport layer/cathode
(l) Anode/light-emitting layer/electron transport layer/charge injection layer/cathode
(m) Anode/charge injection layer/light-emitting layer/electron transport layer/charge injection layer/cathode
(n) Anode/charge injection layer/hole transport layer/light-emitting layer/charge transport layer/cathode
(o) Anode/hole transport layer/light-emitting layer/electron transport layer/charge injection layer/cathode
(p) Anode/charge injection layer/hole transport layer/light-emitting layer/electron transport layer/charge injection layer/cathode

The charge injection layer may be (I) a layer comprising a conductive polymer, (II) a layer provided between the anode and hole transport layer, which comprises a material having an ionization potential between that of the anode material in the anode and the hole transport material in the hole transport layer, or (III) a layer provided between the cathode and electron transport layer, which comprises a material having an electron affinity between that of the cathode material in the cathode and the electron transport material in the electron transport layer.

When the charge injection layer is (I) a layer comprising a conductive polymer, the electric conductivity of the conductive polymer is preferably 10⁻⁵ S/cm to 10³ S/cm, and for reduced leak current between light-emitting picture elements, it is more preferably 10⁻⁵ S/cm to 10² S/cm and most preferably 10⁻⁵ S/cm to 10¹ S/cm. The conductive polymer may be doped with an appropriate amount of ion so that this range is satisfied.

The type of ion used for doping may be an anion for the hole injection layer or a cation for the electron injection layer. Anions include polystyrenesulfonate ion, alkylbenzenesulfonate ion and camphorsulfonate ion, and cations include lithium ion, sodium ion, potassium ion and tetrabutylammonium ion.

The thickness of the charge injection layer is preferably 1-100 nm and more preferably 2-50 nm.

The conductive polymer may be selected in consideration of the relationship between the electrode and the material in the adjacent layer, and examples include conductive polymers, such as polyaniline and its derivatives, polythiophene and its derivatives, polypyrrole and its derivatives, polyphenylenevinylene and its derivatives, polythienylenevinylene and its derivatives, polyquinoline and its derivatives and polyquinoxaline and its derivatives, and polymers comprising an aromatic amine structure on the main chain or a side chain. The charge injection layer may also be a layer comprising a metal phthalocyanine (copper phthalocyanine or the like), or carbon.

The insulating layer have the function of facilitating charge injection. The thickness of the insulating layer is usually 0.1-20 nm, preferably 0.5-10 nm and more preferably 1-5 nm. The material used for the insulating layer may be a metal fluoride, metal oxide, organic insulating material, or the like.

Light-emitting devices with insulating layers include those having the following structures (q)-(ab).
(q) Anode/insulating layer/light-emitting layer/cathode
(r) Anode/light-emitting layer/insulating layer/cathode
(s) Anode/insulating layer/light-emitting layer/insulating layer/cathode
(t) Anode/insulating layer/hole transport layer/light-emitting layer/cathode
(u) Anode/hole transport layer/light-emitting layer/insulating layer/cathode
(v) Anode/insulating layer/hole transport layer/light-emitting layer/insulating layer/cathode
(w) Anode/insulating layer/light-emitting layer/electron transport layer/cathode
(x) Anode/light-emitting layer/electron transport layer/insulating layer/cathode
(y) Anode/insulating layer/light-emitting layer/electron transport layer/insulating layer/cathode
(z) Anode/insulating layer/hole transport layer/light-emitting layer/electron transport layer/cathode
(aa) Anode/hole transport layer/light-emitting layer/electron transport layer/insulating layer/cathode
(ab) Anode/insulating layer/hole transport layer/light-emitting layer/electron transport layer/insulating layer/cathode

The light-emitting device of this embodiment preferably comprises a substrate adjacent to the anode or cathode. The substrate is preferably one with that does not undergo alteration in shape or properties during formation of the electrode and each of the layers, and examples include substrates of glass, plastic, polymer film, silicon and the like. In the case of an opaque substrate, the electrode opposite the electrode in contact with the substrate is preferably transparent or semi-transparent.

In a light-emitting device of this embodiment, normally either or both the electrodes composed of the anode and cathode will be transparent or semi-transparent, and preferably the anode is transparent or semi-transparent.

The material of the anode may be a conductive metal oxide film or a semi-transparent metal film. Specifically, there may be used a film formed using a conductive inorganic compound, such as indium oxide, zinc oxide, tin oxide, a complex oxide composed of indium tin oxide (ITO), a complex oxide composed of indium zinc oxide, or NESA, gold, platinum, silver, copper or the like. The anode used may be an organic transparent conductive film made of polyaniline or its derivative or polythiophene or its derivative. In order to facilitate charge injection, there may be provided on the anode a layer composed of a phthalocyanine derivative, conductive polymer, carbon or the like, or a layer composed of a metal oxide, metal fluoride, organic insulating material or the like.

The method of forming the anode may be a vacuum vapor deposition method, a sputtering method, an ion plating method, a plating method or the like.

The thickness of the anode may be appropriately selected in consideration of light permeability and electric conductivity, and it will usually be 10 nm to 10 µm, preferably 20 nm to 1 µm and more preferably 50 nm to 500 nm.

The material for the cathode is preferably one with a low work function, e.g. a metal such as lithium, sodium, potassium, rubidium, cesium, beryllium, magnesium, calcium, strontium, barium, aluminum, scandium, vanadium, zinc, yttrium, indium, cerium, samarium, europium, terbium or ytterbium, or an alloy comprising two or more of these metals, or an alloy comprising one or more of these metals with one or more of gold, silver, platinum, copper, manganese, titanium, cobalt, nickel, tungsten or tin, or graphite or a graphite interlaminar compound.

The method used to form the cathode may be a vacuum vapor deposition method, a sputtering method, or a laminating method involving thermocompression bonding of a metal film.

The thickness of the cathode may be appropriately selected in consideration of electric conductivity and durability, and it will usually be 10 nm to 10 µm, preferably 20 nm to 1 µm and more preferably 50 nm to 500 nm.

Also, between the cathode and the light-emitting layer or between the cathode and the electron transport layer, there may be provided a layer composed of a conductive polymer, or a layer composed of a metal oxide, metal fluoride or organic insulating material, and a protective layer for protection of the light-emitting device may also be placed after formation of the cathode. For prolonged stable use of the light-emitting device, a protective layer and/or protective cover is preferably situated to protect the element from the external environment.

Such a protective layer may be a resin, a metal oxide, metal fluoride, metal boride, or the like. The protective cover may be a glass plate, or a plastic sheet that has been subjected to low-permeability treatment on the surface, and the protective cover may be hermetically attached to the element board with a thermosetting resin or photocuring resin. A spacer may be used to maintain spacing, thus helping to prevent damage to the element. By filling an inert gas such as nitrogen or argon into the spacing, it is possible to prevent oxidation of the cathode, and setting a desiccant such as barium oxide in the space will help to prevent damage to the element by moisture adsorbed during the production steps.

The polymer compound of this embodiment, or a light-emitting device comprising the polymer composition of this embodiment, are useful for a surface light source such as a curved light source or flat light source (for example, illumination); or for display devices such as segment display devices, dot matrix display devices (for example, dot matrix flat displays), and liquid crystal display devices (for example, liquid crystal display devices and liquid crystal display backlights). In addition to being suitable as a material for use in such fabrication, the polymer compound of this embodiment is also useful as a laser pigment, an organic solar cell material, an organic transistor organic semiconductor, a conductive film material for a conductive film or an organic semiconductor film, a light-emitting film material that emits fluorescence, or a material for a polymer field-effect transistor.

A planar anode and cathode may be stacked together in order to obtain planar luminescence using the light-emitting device of this embodiment. Also, luminescence in a pattern can be obtained by a method in which a mask with a patterned window is set on the front side of the planar light-emitting device, or a method in which an anode or cathode, or both electrodes, are formed in a pattern shape. By forming a pattern by any of these methods, and configuring some electrodes to be independently ON/OFF switchable, it is possible to obtain a segment type display device allowing display of numerals, letters or simple symbols.
Furthermore, for a dot matrix display device, the anode and cathode may both be formed as stripes and configured in a crossing manner. A partial color display or multicolor display can also be formed by a method in which different types of polymer compounds with different light-emitting colors are coated or a method using a color filter or fluorescence conversion filter. The dot matrix display device may be passively driven or actively driven in combination with a TFT or the like. These display devices may be used for computers, televisions, portable terminals, cellular phones, car navigation systems, video camera viewfinders, and the like.

### Examples

The invention will now be described in greater detail by examples, with the understanding that the invention is not limited thereto.

The polystyrene-equivalent number-average molecular weights and weight-average molecular weights of the polymer compounds were determined by gel permeation chromatography (GPC, trade name: LC-10Avp by Shimadzu Corp.), under the following measuring conditions.

### <Measuring conditions>

The polymer compound to be measured was dissolved in tetrahydrofuran to a concentration of about 0.05 wt% and 10 µL thereof was injected into the GPC. The GPC mobile phase was tetrahydrofuran, and the flow rate was 2.0 mL/min. The column used was a PLgel MIXED-B (product of Polymer Laboratories, Ltd.). The detector used was a differential refractometer (trade name: RID-10A, product of Shimadzu Corp.).

### <Synthesis of monomer containing benzo[k]fluoranthene backbone>

### [Example 1]

### {Synthesis of compound 1}

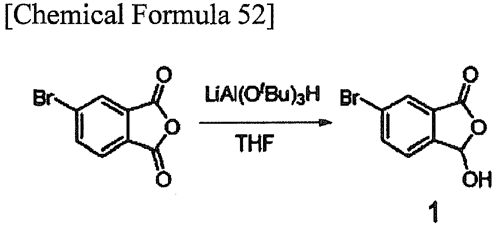

After placing 5-bromophthalic anhydride (23.2 g, 100.2 mmol) in a 1 L four-necked volumetric flask and adding THF (430 mL) to dissolution, the gas in the flask was exchanged with nitrogen. After cooling to -66°C, lithium tri-*tert*-butoxyaluminum hydride (100.2 mL, 100.2 mmol, 1.0 M THF solution) was added dropwise. After stirring for 2 hours at no higher than -65°C, water (100 mL) and dilute hydrochloric acid (400 mL) were added to suspend the reaction. The reaction solution was separated into the aqueous layer and organic layer, the organic layer obtained by extracting the aqueous layer twice with ethyl acetate (400 mL) was combined with the previous organic layer, and then the obtained organic layer was dried over anhydrous sodium sulfate, filtered and concentrated to obtain 23.5 g of compound 1 as a white solid. The product at this stage was used for the following reaction without any further purification.

### {Synthesis of compound 2}

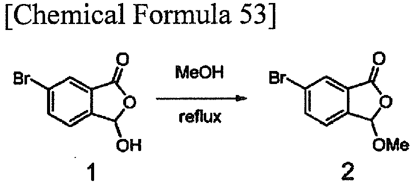

After placing compound 1 (23.45 g) in a 300 mL volumetric flask, methanol (232 mL) was added to dissolution, and then the gas in the flask was exchanged with nitrogen. The mixture was heated at 80°C for 6 hours for reflux. The solution obtained by subsequent cooling was concentrated, ethyl acetate (100 mL) and water (100 mL) were added, and the aqueous layer and organic layer were allowed to separate. Next, the organic layer obtained by extracting the aqueous layer with ethyl acetate (100 mL) was combined with the organic layer, and the obtained organic layer was rinsed with brine (100 mL). The rinsed organic layer was dried over anhydrous sodium sulfate, filtered and concentrated to obtain 20.3 g of compound 2 as a pale yellow oil.

### { Synthesis of compound 3}

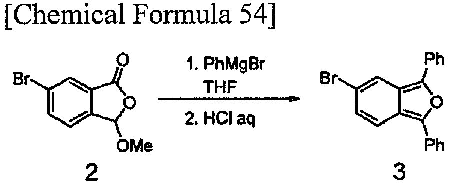

After placing compound 2 (16.2 g) in a 1 L four-necked volumetric flask, THF (267 mL) was added to dissolution, and then the gas in the flask was exchanged with nitrogen. After cooling to 0°C, phenylmagnesium bromide (110.0 mL, 110.0 mmol, 1.0 M THF solution) was added dropwise, and the mixture was stirred for 3 hours at the same temperature, after which dilute hydrochloric acid (200 mL) was added dropwise to suspend the reaction. The reaction solution was separated into the aqueous layer and organic layer, and the organic layer obtained by extracting the aqueous layer twice with ethyl acetate (300 mL) was combined with the previous organic layer, and the obtained organic layer was rinsed with water (300 mL). The rinsed organic layer was dried over anhydrous sodium sulfate, filtered and concentrated to obtain 22.1 g of compound 3.

### {Synthesis of compound 4}

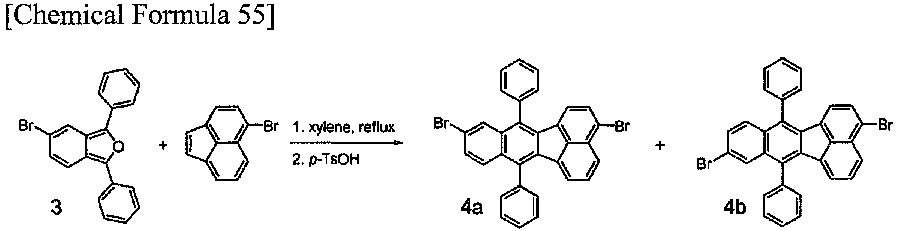

After placing compound 3 (22.1 g) and 5-bromoacenaphthylene (12.1 g, 52.2 mmol) in a 300 mL volumetric flask, xylene (182 mL) was added for dissolution, and then the gas in the flask was exchanged with nitrogen. The mixture was heated at 150°C for 4 hours for reflux and then allowed to cool to room temperature, p-toluenesulfonic acid (2.98 g) was added, and the mixture was stirred at 110°C for 5 hours. The solution obtained by cooling was then removed of the solvent by reduced-pressure distillation. For removal of the coloring components, it was dissolved in a hexane/toluene = 20/1 liquid mixture (100 mL) and then allowed to separate into the aqueous layer and organic layer, the organic layer obtained by extracting the aqueous layer twice with toluene (200 mL) was combined with the previous organic layer, and the obtained organic layer was rinsed with an aqueous saturated sodium hydrogencarbonate solution (200 mL) and water (200 mL). The rinsed organic layer was dried over anhydrous sodium sulfate, filtered and concentrated to obtain a crude product, which was purified using a silica gel column (hexane) to obtain 13.3 g of compound 4 (mixture of compounds 4a and 4b) as a light yellow solid. Measurement by ¹H-NMR indicated that two different isomers (4a, 4b) had been produced in a molar ratio of 1:1.
LC-MS (APPI, positive): [M+H]⁺561.8

### [Example 2]

### {Synthesis of compound 5}

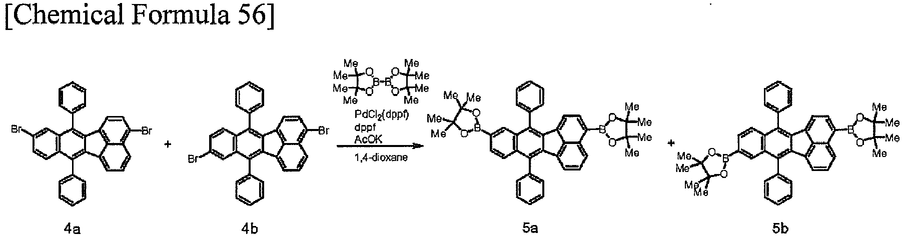

After placing compound 4 (mixture of compounds 4a and 4b) (5.0 g, 8.75 mmol), bispinacolatodiboron (4.89 g) and potassium acetate (5.15 g) in a 200 mL four-necked flask, the gas in the flask was exchanged with nitrogen. To this there were added 1,4-dioxane (50 mL), palladium chloride (diphenylphosphinoferrocene)(PdCl₂(dppf)) (0.43 g) and diphenylphosphinoferrocene (dppf) (0.29 g), and the mixture was stirred at 105°C for 17 hours. The obtained solution was cooled to room temperature, and then filtered with a funnel precoated with Celite. The concentrate obtained by concentrating the filtrate under reduced pressure was dissolved in hexane, and then active carbon was added and the mixture was stirred while heating at 70°C for 1 hour. The obtained mixture was cooled to room temperature, and then filtered with a funnel precoated with Celite. To the oil obtained by concentrating the filtrate under reduced pressure there was added acetonitrile (200 mL), and the precipitated solid was filtered out to obtain 3.7 g of compound 5 (mixture of compounds 5a and 5b) as a yellow solid.

### {Synthesis of compound 6}

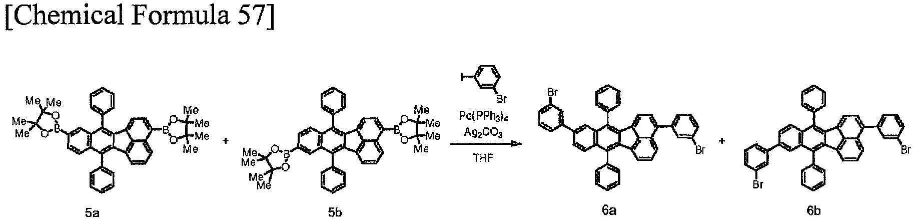

After placing compound 5 (mixture of compounds 5a and 5b) (3.61 g, 5.00 mmol), 3-bromoiodobenzene (5.72 g) and silver carbonate (2.76 g) in a 500 mL three-necked flask, the gas in the flask was exchanged with nitrogen. To this there were added THF (122 mL) and tetrakis(triphenylphosphine)palladium (289 mg), and the mixture was heated at 50°C for 7 hours. The obtained solution was cooled to room temperature, and then filtered with a funnel precoated with Celite. The concentrate obtained by concentrating the filtrate under reduced pressure was purified using a silica gel column (hexane/chloroform = 5/1), to obtain 1.36 g of compound 6 (mixture of compounds 6a and 6b) as a light yellow solid.
LC-MS (APPI, positive): [M+H]⁺714.9

### [Example 3]

### {Synthesis of compound 7}

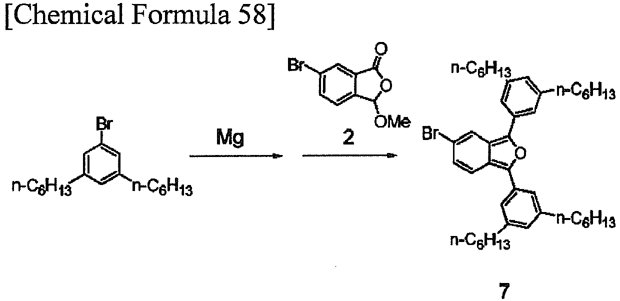

After placing magnesium (4.6 g) and THF (50 mL) in a 300 mL four-necked volumetric flask, the gas in the flask was exchanged with nitrogen. After then adding 3,5-dihexylbromobenzene (40.9 g) dropwise, THF (75 mL) was added and the mixture was heated for 1 hour for reflux to prepare a Grignard reagent.
Compound 2 (15.3 g) was placed in a 1 L four-necked volumetric flask and dissolved in THF (300 mL). The previously prepared Grignard reagent was added dropwise at no higher than -5°C, and after stirring for 5 hours at that temperature, dilute hydrochloric acid (300 mL) was added dropwise to suspend the reaction. The reaction solution was separated into the aqueous layer and organic layer, the organic layer obtained by extracting the aqueous layer twice with chloroform (250 mL) was combined with the previous organic layer, and the obtained organic layer was rinsed with brine (300 mL). The rinsed organic layer was dried over anhydrous sodium sulfate, filtered and concentrated to obtain 42.6 g of compound 7.

### {Synthesis of compound 8}

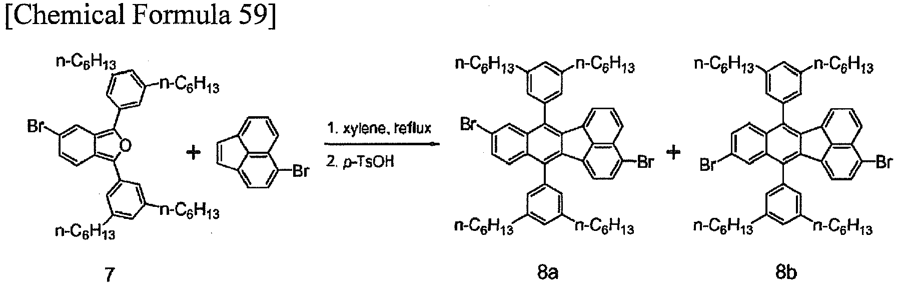

After placing compound 7 (42.6 g) and 5-bromoacenaphthylene (17.1 g, 62.9 mmol) in a 500 mL volumetric flask, xylene (290 mL) was added for dissolution, and then the gas in the flask was exchanged with nitrogen. The mixture was heated at 150°C for 4 hours for reflux and then allowed to cool to room temperature, p-toluenesulfonic acid (3.59 g) was added, and the mixture was stirred at 110°C for 4 hours. Next, the solution which had been allowed to cool was separated into the aqueous layer and organic layer, and the organic layer obtained by extracting the aqueous layer twice with toluene (200 mL) was combined with the previous organic layer, and the obtained organic layer was rinsed with an aqueous saturated sodium hydrogencarbonate solution (300 mL) and brine (200 mL). The rinsed organic layer was dried over anhydrous sodium sulfate, filtered and concentrated to obtain a crude product, which was purified using a silica gel column (hexane) to obtain 8.9 g of compound 8 (mixture of compounds 8a and 8b) as a pale yellow oil.

### {Synthesis of compound 9}

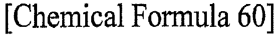

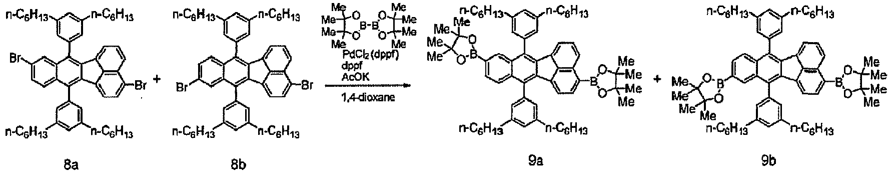

After placing compound 8 (mixture of compounds 8a and 8b) (8.9 g, 9.82 mmol), bispinacolatodiboron (5.49 g) and potassium acetate (5.84 g) in a 300 mL four-necked flask, the gas in the flask was exchanged with nitrogen. To this there were added 1,4-dioxane (44 mL), palladium chloride (diphenylphosphinoferrocene)(PdCl₂(dppf)) (0.48 g) and diphenylphosphinoferrocene (dppf) (0.34 g), and the mixture was stirred at 105°C for 8.5 hours. The obtained solution was cooled to room temperature, and then filtered with a funnel precoated with Celite. The concentrate obtained by concentrating the filtrate under reduced pressure was dissolved in hexane, and then active carbon was added and the mixture was stirred while heating at 70°C for 1 hour. The obtained mixture was cooled to room temperature, and then filtered with a funnel precoated with Celite. The filtrate was concentrated under reduced pressure to obtain 10.5 g of compound 9 (mixture of compounds 9a and 9b) as a yellow oil.
LC-MS (ESI, KCl): [M+K]⁺1032.6

### {Synthesis of compound 10}

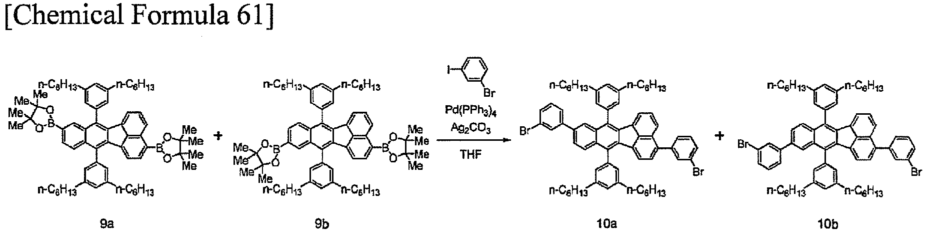

After placing compound 9 (mixture of compounds 9a and 9b) (9.75 g, 9.82 mmol), 3-bromoiodobenzene (28.3 g) and silver carbonate (27.3 g) in a 200 mL volumetric flask, the gas in the flask was exchanged with nitrogen. To this there were added THF (100 mL) and tetrakis(triphenylphosphine)palladium (567 mg), and the mixture was heated at 35°C for 37 hours. The obtained solution was cooled to room temperature, and then filtered with a funnel precoated with Celite and silica gel. The concentrate obtained by concentrating the filtrate under reduced pressure was purified using a silica gel column (hexane/chloroform = 5/1), to obtain 3.90 g of compound 10 (mixture of compounds 10a and 10b) as a pale yellow oil.
LC-MS (APPI, positive): [M+H]⁺1049.3

### [Example 4]

### {Synthesis of compound 11}

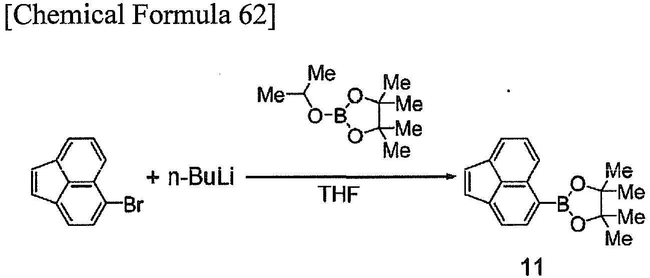

After placing 5-bromoacenaphthylene (10.0 g, 43.27 mmol) in a 300 mL volumetric flask and exchanging the gas in the flask with argon, 102 mL of anhydrous tetrahydrofuran was added and the mixture was cooled to -78°C. Next, an n-butyllithium hexane solution (2.73 mol/L, 17 mL) was added dropwise over a period of 15 minutes, and the mixture was warmed for 1 hour. After then adding 2-isopropoxy-4,4,5,5-tetramethyl-1,3,2-dioxaborolane (10.1 g, 54.5 mmol) dropwise over a period of 15 minutes, the mixture was stirred for 30 minutes. It was then increased to room temperature, water (1 g) was added, and the concentrate obtained by concentration was purified using a silica gel column (hexane/toluene = 3/1), to obtain 10.3 g of compound 11 as an orange solid.

### {Synthesis of compound 12}

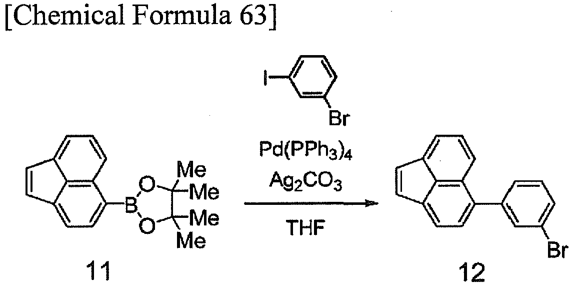

After placing compound 11 (5.2 g, 15 mmol), silver carbonate (8.3 g, 30 mmol), m-bromoiodobenzene (17.2 g, 60 mmol) and anhydrous tetrahydrofuran (174 mL) in a 300 mL volumetric flask that had been exchanged with argon, nitrogen was bubbled through for 10 minutes at room temperature. After increasing the temperature to 50°C, palladium [tetrakis(triphenylphosphine)] (0.87 g, 0.75 mmol) was added, and the mixture was stirred while warming for 6 hours. After then cooling the reaction solution to room temperature, water and toluene were added and the aqueous layer and organic layer were allowed to separate. The organic layer was dried over sodium sulfate, filtered and then concentrated to obtain a concentrate, which was purified using a silica gel column (hexane) to obtain 5.9 g of compound 12 as an orange oil.

### {Synthesis of compound 13}

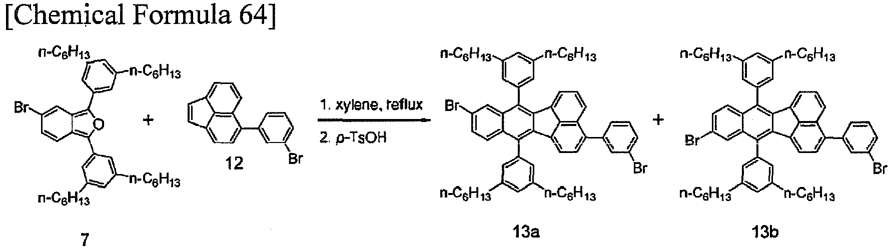

After placing compound 7 (9.7 g, 10 mmol) and compound 12 (3.9 g, 10 mmol) in a 300 mL volumetric flask, xylene (124 mL) was added to dissolution, and then the gas in the flask was exchanged with nitrogen. The mixture was stirred for 1 hour while heating at 140°C for reflux and then cooled to 110°C, and then p-toluenesulfonic acid (0.53 g) was added and the mixture was stirred at 110°C for 5 hours. It was then allowed to cool to room temperature, water and toluene were added, the aqueous layer and organic layer were allowed to separate, and the organic layer was further rinsed with 5 wt% sodium carbonate water. The rinsed organic layer was dried over anhydrous sodium sulfate, filtered and concentrated to obtain a concentrate, which was purified using a silica gel column (hexane) to obtain 5.8 g of compound 13 (mixture of compounds 13a and 13b) as a light yellow solid. Measurement by ¹H-NMR indicated that two different isomers (13a, 13b) had been produced in a molar ratio of 1:1.
LC-MS (APCI, positive): [M+H]⁺973

### <Synthesis of polymer compounds A to J>

### [Example 5]

Synthesis of a polymer (polymer compound A), comprising a constitutional unit represented by the following formula (K-1) (the abundance ratio (molar ratio) of the 2 different constitutional units being approximately 50:50), and a constitutional unit represented by the following formula (K-2) in a molar ratio of 10:90. 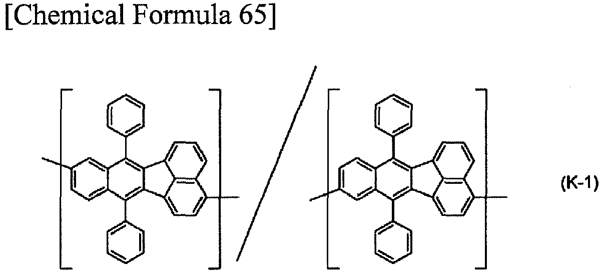 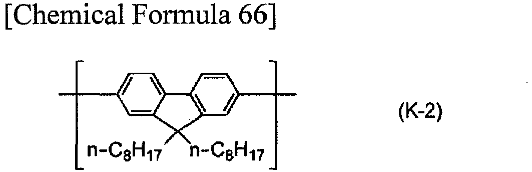 After mixing a compound represented by the following formula (M-2-B): 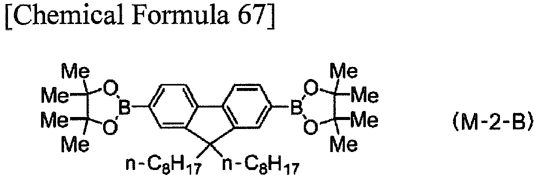 (1.285 g, 2.00 mmol),
a compound represented by the following formula (M-2-Br): 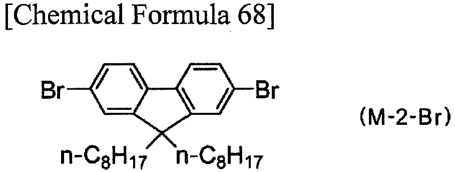 (0.878 g, 1.60 mmol), compound 4 synthesized in Example 1 (0.225 g, 0.40 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 0.62 g of polymer compound A. The polystyrene-equivalent number-average molecular weight of polymer compound A was 1.14 × 10⁵, and the polystyrene-equivalent weight-average molecular weight was 2.97 × 10⁵.

### [Example 6]

Synthesis of a polymer (polymer compound B), comprising a constitutional unit represented by the following formula (K-1) (the abundance ratio (molar ratio) of the 2 different constitutional units being approximately 50:50), a constitutional unit represented by the following formula (K-2), a constitutional unit represented by the following formula (K-3) and a constitutional unit represented by the following formula (K-4) in a molar ratio of 3:14:5:78.

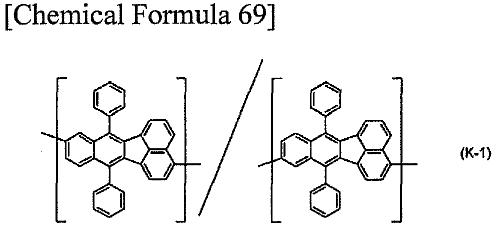

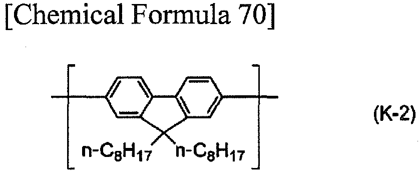

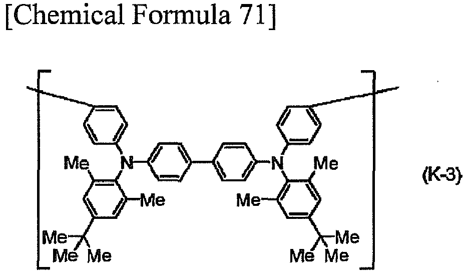

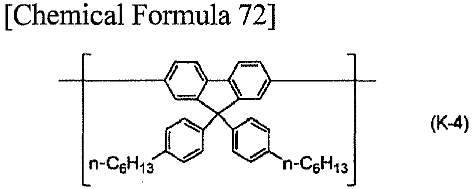

After mixing a compound represented by the following formula (M-3-Br): 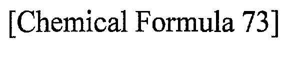 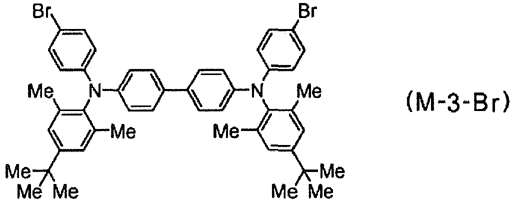 (0.163 g, 0.20 mmol),
a compound represented by the following formula (M-2-B): 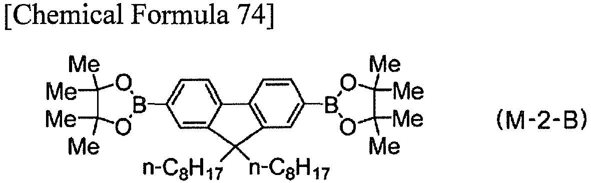 (0.360 g, 0.56 mmol),
a compound represented by the following formula (M-4-B): 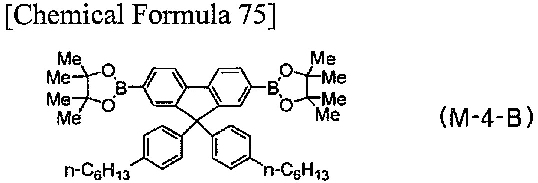 (1.064 g, 1.44 mmol),
a compound represented by the following formula (M-4-Br): 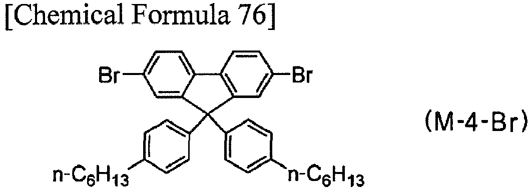 (1.083 g, 1.68 mmol), compound 4 synthesized in Example 1 (0.067 g, 0.12 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 1.33 g of polymer compound B. The polystyrene-equivalent number-average molecular weight of polymer compound B was 9.40 × 10⁴, and the polystyrene-equivalent weight-average molecular weight was 2.59 × 10⁵.

### [Example 7]

Synthesis of a polymer (polymer compound C), comprising a constitutional unit represented by the following formula (K-1) (the abundance ratio (molar ratio) of the 2 different constitutional units being approximately 50:50), a constitutional unit represented by the following formula (K-2), a constitutional unit represented by the following formula (K-3), a constitutional unit represented by the following formula (K-5) and a constitutional unit represented by the following formula (K-6) in a molar ratio of 5:14:5:36:40.

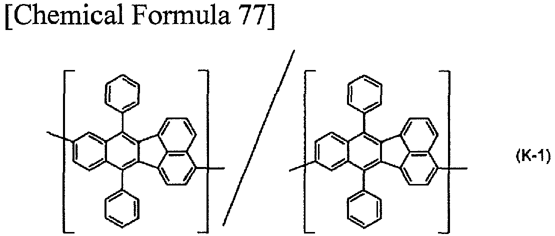

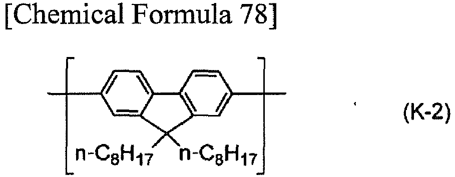

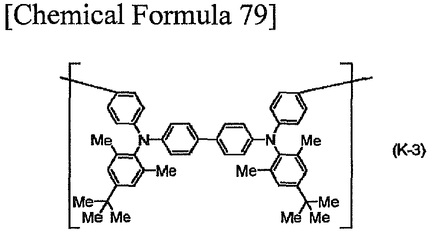

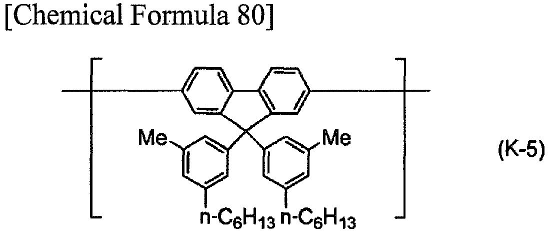

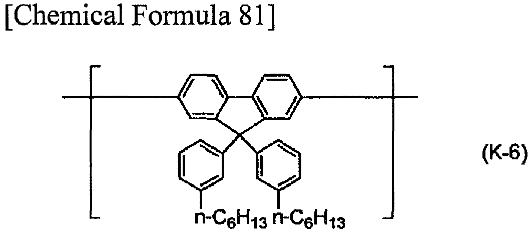

After mixing a compound represented by the following formula (M-3-Br): 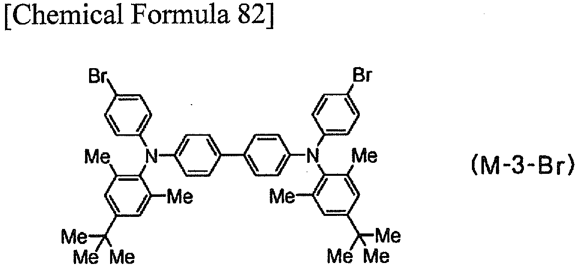 (0.163 g, 0.20 mmol),
a compound represented by the following formula (M-2-B): 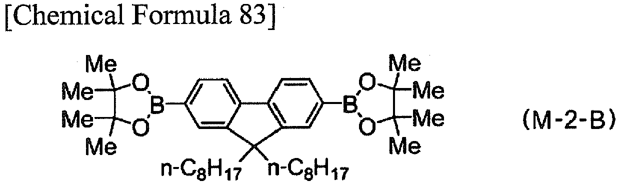 (0.360 g, 0.56 mmol),
a compound represented by the following formula (M-5-B): 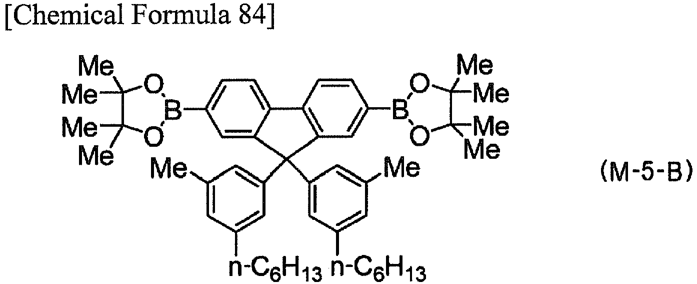 (1.104 g, 1.44 mmol),
a compound represented by the following formula (M-6-Br): 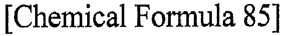 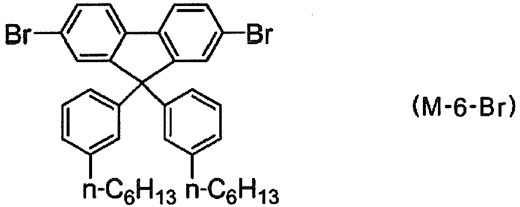 (1.031 g, 1.60 mmol), compound 4 synthesized in Example 1 (0.112 g, 0.20 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was then added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 1.36 g of polymer compound C. The polystyrene-equivalent number-average molecular weight of polymer compound C was 1.03 × 10⁵, and the polystyrene-equivalent weight-average molecular weight was 3.02 × 10⁵.

### [Example 8]

Synthesis of a polymer (polymer compound D), comprising a constitutional unit represented by the following formula (K-7) (the abundance ratio (molar ratio) of the 2 different constitutional units being approximately 50:50), a constitutional unit represented by the following formula (K-2), a constitutional unit represented by the following formula (K-3), a constitutional unit represented by the following formula (K-5) and a constitutional unit represented by the following formula (K-6) in a molar ratio of 3:14:5:36:42.

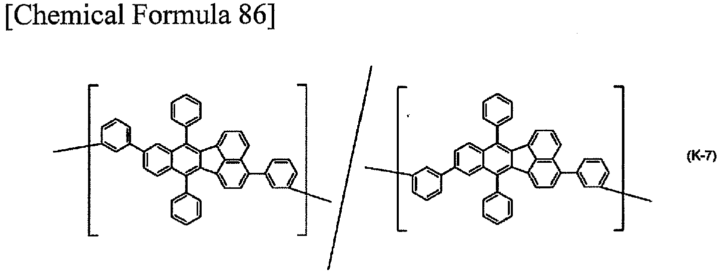

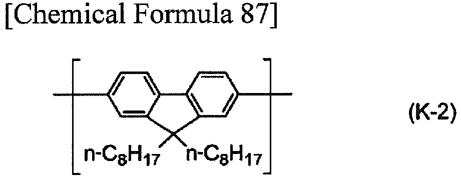

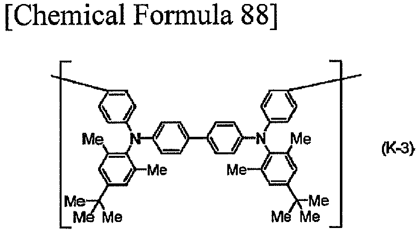

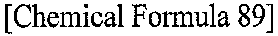

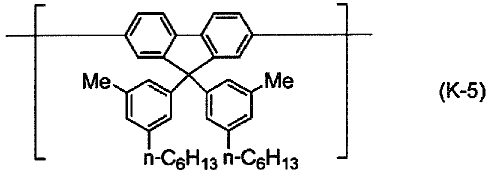

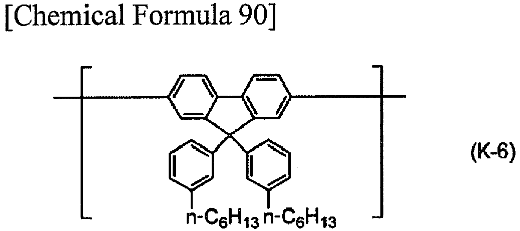

After mixing a compound represented by the following formula (M-3-Br): 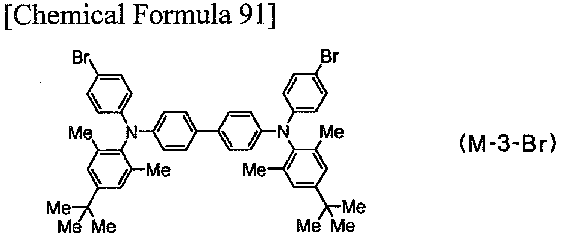 (0.163 g, 0.20 mmol),
a compound represented by the following formula (M-2-B): 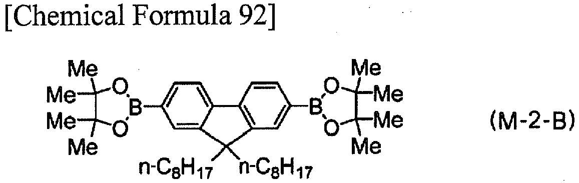 (0.360 g, 0.56 mmol),
a compound represented by the following formula (M-5-B): 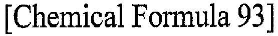 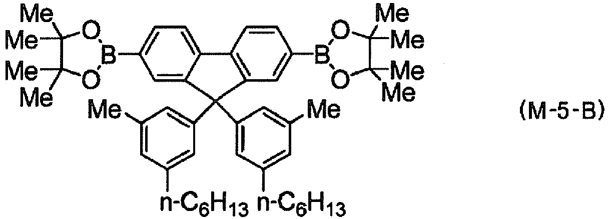 (1.104 g, 1.44 mmol),
a compound represented by the following formula (M-6-Br): 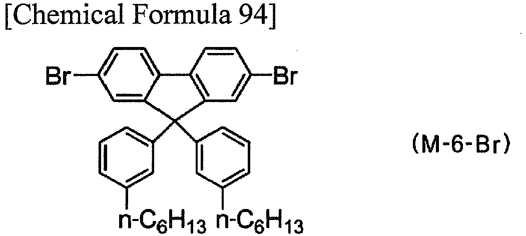 (1.083 g, 1.68 mmol), compound 6 synthesized in Example 2 (0.086 g, 0.12 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 1.49 g of polymer compound D. The polystyrene-equivalent number-average molecular weight of polymer compound D was 1.18 × 10⁵, and the polystyrene-equivalent weight-average molecular weight was 3.32 × 10⁵.

### [Example 9]

Synthesis of a polymer (polymer compound E), comprising a constitutional unit represented by the following formula (K-7) (the abundance ratio (molar ratio) of the 2 different constitutional units being approximately 50:50), a constitutional unit represented by the following formula (K-2), a constitutional unit represented by the following formula (K-5) and a constitutional unit represented by the following formula (K-6) in a molar ratio of 10:14:36:40.

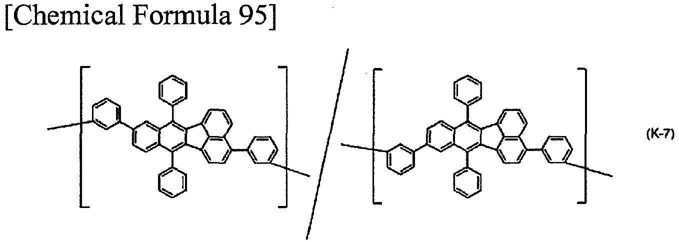

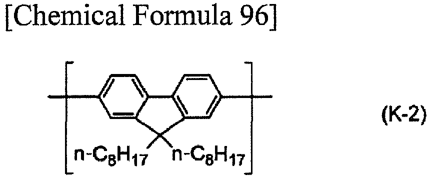

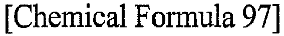

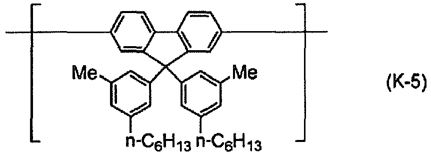

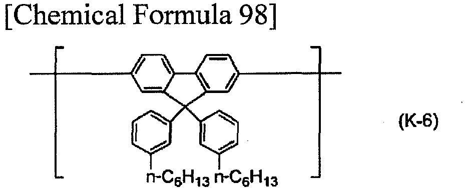

After mixing a compound represented by the following formula (M-2-B): 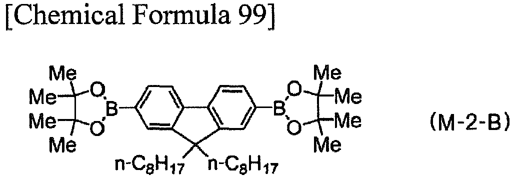 (0.360 g, 0.56 mmol),
a compound represented by the following formula (M-5-B): 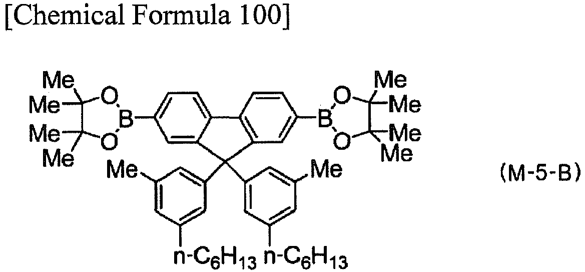 (1.104 g, 1.44 mmol),
a compound represented by the following formula (M-6-Br): 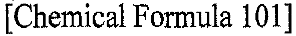 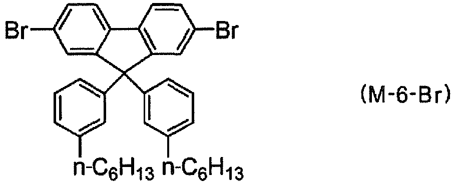 (1.031 g, 1.60 mmol), compound 6 synthesized in Example 2 (0.286 g, 0.40 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 1.3 g of polymer compound E. The polystyrene-equivalent number-average molecular weight of polymer compound E was 8.30 × 10⁴, and the polystyrene-equivalent weight-average molecular weight was 2.79 × 10⁵.

### [Example 10]

Synthesis of a polymer (polymer compound F), comprising a constitutional unit represented by the following formula (K-7) (the abundance ratio (molar ratio) of the 2 different constitutional units being approximately 50:50), a constitutional unit represented by the following formula (K-2), a constitutional unit represented by the following formula (K-3) and a constitutional unit represented by the following formula (K-4) in a molar ratio of 5:14:5:76.

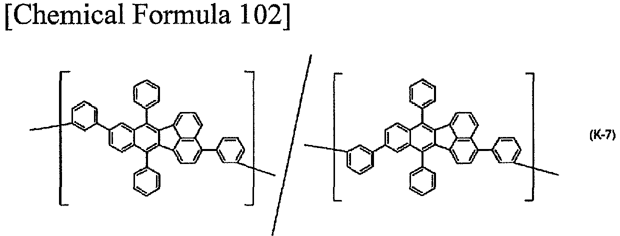

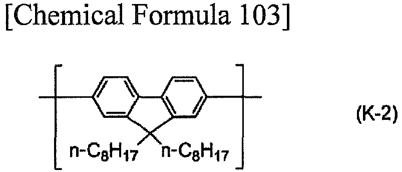

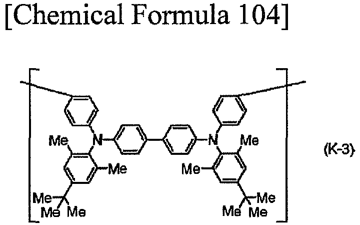

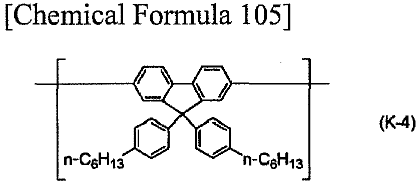

After mixing a compound represented by the following formula (M-3-Br): 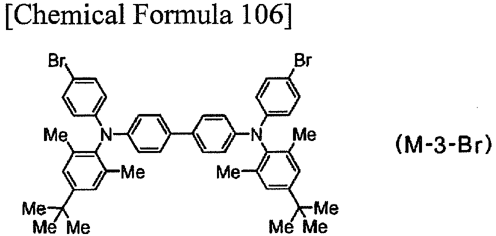 (0.163 g, 0.20 mmol),
a compound represented by the following formula (M-2-B): 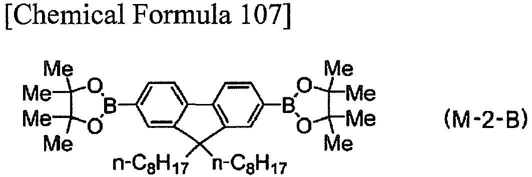 (0.360 g, 0.56 mmol),
a compound represented by the following formula (M-4-B): 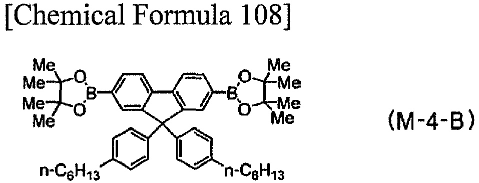 (1.064 g, 1.44 mmol),
a compound represented by the following formula (M-4-Br): 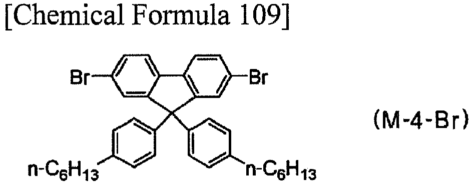 (1.031 g, 1.60 mmol), compound 6 synthesized in Example 2 (0.143 g, 0.20 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 1.4 g of polymer compound F. The polystyrene-equivalent number-average molecular weight of polymer compound F was 8.00 × 10⁴, and the polystyrene-equivalent weight-average molecular weight was 2.90 × 10⁵.

### [Example 11]

Synthesis of a polymer (polymer compound G), comprising a constitutional unit represented by the following formula (K-8) (the abundance ratio (molar ratio) of the 2 different constitutional units being approximately 50:50), a constitutional unit represented by the following formula (K-2), a constitutional unit represented by the following formula (K-5) and a constitutional unit represented by the following formula (K-6) in a molar ratio of 10:14:36:40.

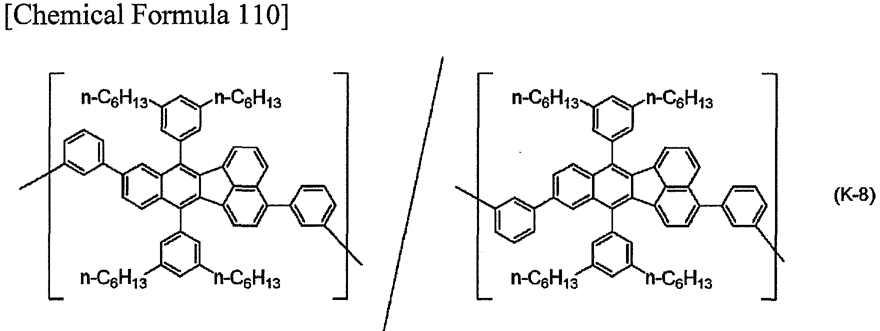

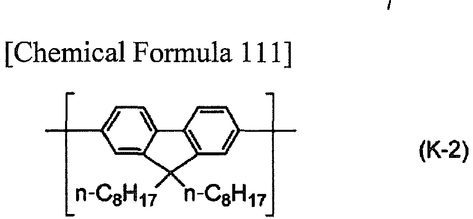

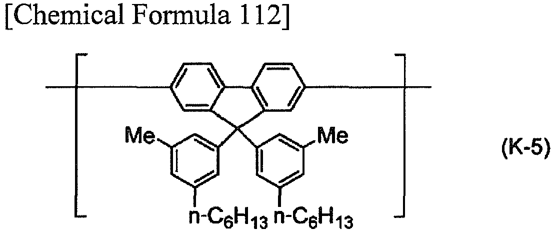

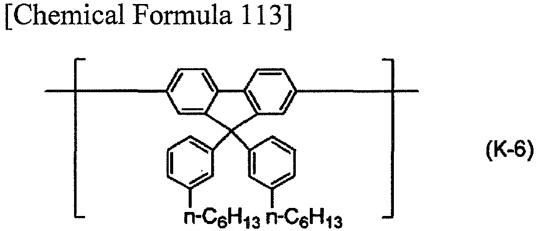

After mixing a compound represented by the following formula (M-2-B): 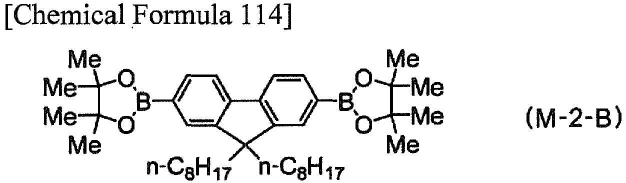 (0.360 g, 0.56 mmol),
a compound represented by the following formula (M-5-B): 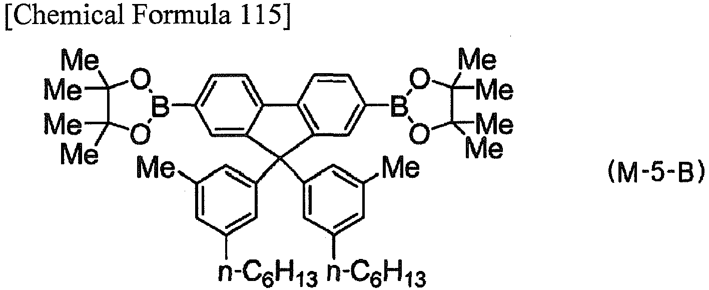 (1.104 g, 1.44 mmol),
a compound represented by the following formula (M-6-Br): 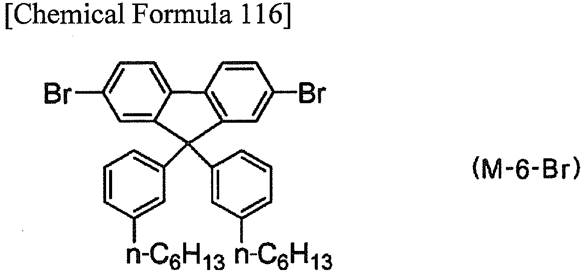 (1.031 g, 1.60 mmol), compound 10 synthesized in Example 3 (0.420 g, 0.40 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 1.4 g of polymer compound G. The polystyrene-equivalent number-average molecular weight of polymer compound G was 7.00 × 10⁴, and the polystyrene-equivalent weight-average molecular weight was 2.07 × 10⁵.

### [Example 12]

Synthesis of a polymer (polymer compound H), comprising a constitutional unit represented by the following formula (K-9) (the abundance ratio (molar ratio) of the 2 different constitutional units being approximately 50:50), a constitutional unit represented by the following formula (K-2), a constitutional unit represented by the following formula (K-3) and a constitutional unit represented by the following formula (K-4) in a molar ratio of 5:14:5:76.

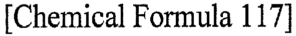

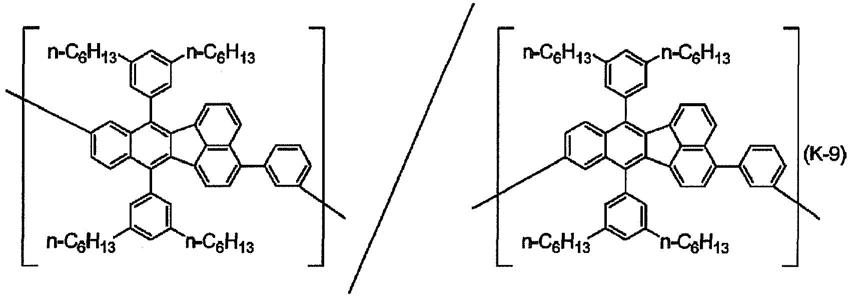

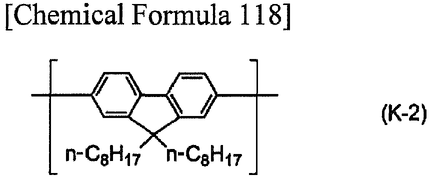

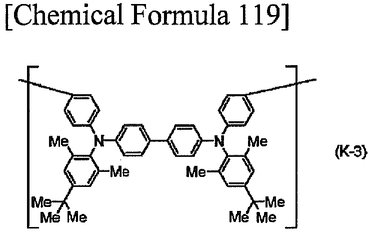

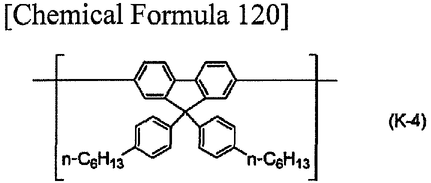

After mixing a compound represented by the following formula (M-3-Br): 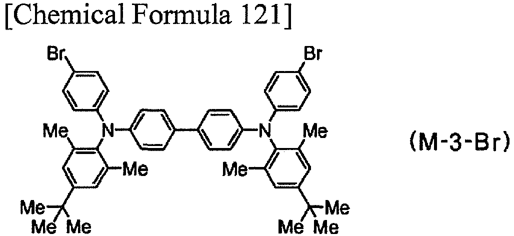 (0.163 g, 0.20 mmol),
a compound represented by the following formula (M-2-B): 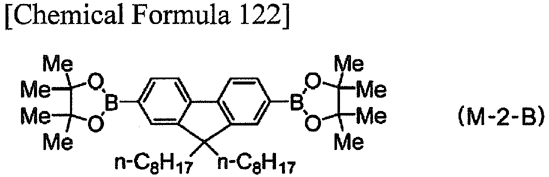 (0.360 g, 0.56 mmol),
a compound represented by the following formula (M-4-B): 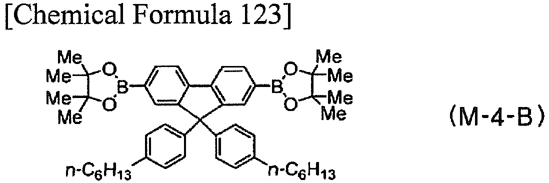 (1.064 g, 1.44 mmol),
a compound represented by the following formula (M-4-Br): 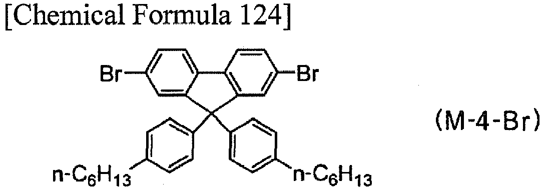 (1.031 g, 1.60 mmol), compound 13 synthesized in Example 4 (0.195 g, 0.20 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 1.4 g of polymer compound H. The polystyrene-equivalent number-average molecular weight of polymer compound H was 8.8 × 10⁴, and the polystyrene-equivalent weight-average molecular weight was 2.53 × 10⁵.

### [Synthesis Example 1]

Synthesis of a polymer (polymer compound I), comprising a constitutional unit represented by the following formula (K-10) and a constitutional unit represented by the following formula (K-2) in a molar ratio of 10:90.

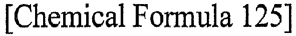

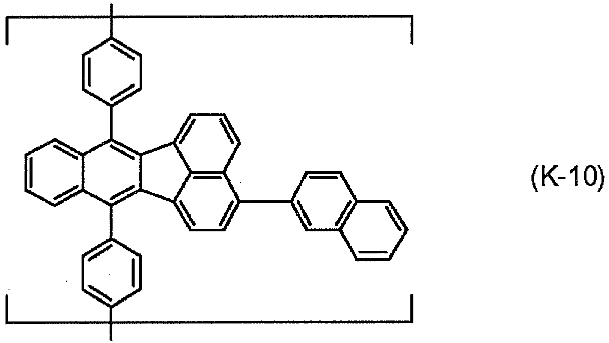

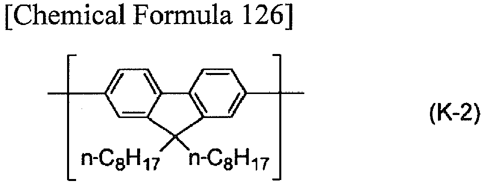

After mixing a compound represented by the following formula (M-2-B): 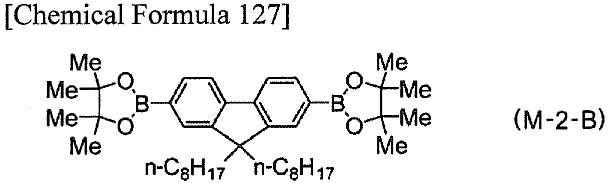 (1.285 g, 2.00 mmol),
a compound represented by the following formula (M-2-Br): 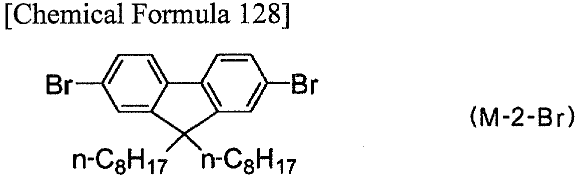 (0.878 g, 1.60 mmol),
a compound represented by the following formula (M-10-Br): 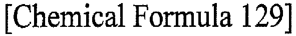 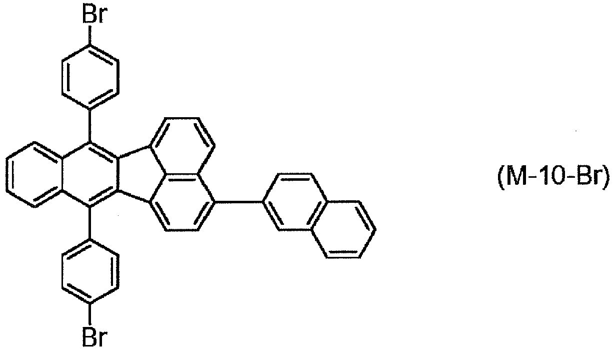 (0.275 g, 0.40 mmol), dichlorobis(triphenylphosphine)palladium (1.4 mg) and toluene (50 mL) under an argon atmosphere, the mixture was heated at 105°C.
A 20 wt% aqueous tetraethylammonium hydroxide solution (6.6 mL) was added dropwise to the reaction solution, which was then refluxed for 2 hours and 40 minutes. After the reaction, phenylboric acid (24 mg) and toluene (5 mL) were added and reflux was continued for another 18.5 hours. Next, an aqueous sodium diethyldithiacarbaminate solution was added and the mixture was stirred at 80°C for 2 hours. After cooling, the organic layer was rinsed twice with water (26 mL), twice with an aqueous 3 wt% acetic acid solution (26 mL) and twice with water (26 mL), and the obtained solution was added dropwise to methanol (400 mL), producing a precipitate which was filtered to obtain the precipitate. The precipitate was dissolved in toluene (80 mL) and passed through an alumina column and a silica gel column in that order for purification. The obtained solution was added dropwise to methanol (400 mL) and stirred, and then the resulting precipitate was filtered out and dried to obtain 1.10 g of polymer compound I. The polystyrene-equivalent number-average molecular weight of polymer compound I was 1.80 × 10⁵, and the polystyrene-equivalent weight-average molecular weight was 4.81 × 10⁵.

### [Synthesis Example 2]

Synthesis of a polymer (polymer compound J), comprising a constitutional unit represented by the following formula (K-11), a constitutional unit represented by the following formula (K-12) and a constitutional unit represented by the following formula (K-2) in a molar ratio of 47.5:2.5:50.

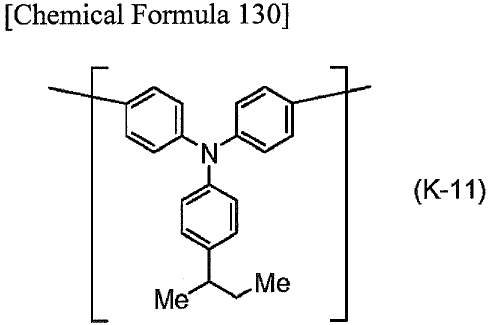

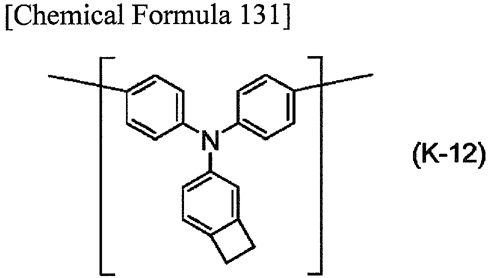

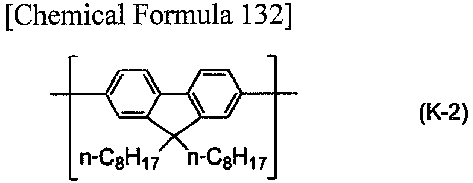

After mixing a compound represented by the following formula (M-2-Z): 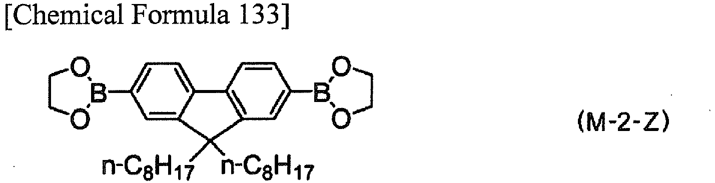 (3.863 g, 7.283 mmol),
a compound represented by the following formula (M-3-Z1): 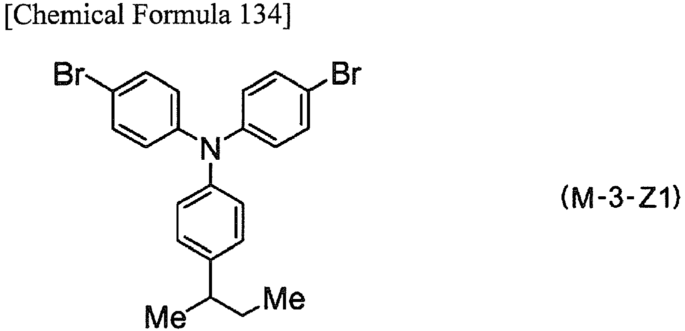 (3.177 g, 6.919 mmol),
a compound represented by the following formula (M-2-Z2): 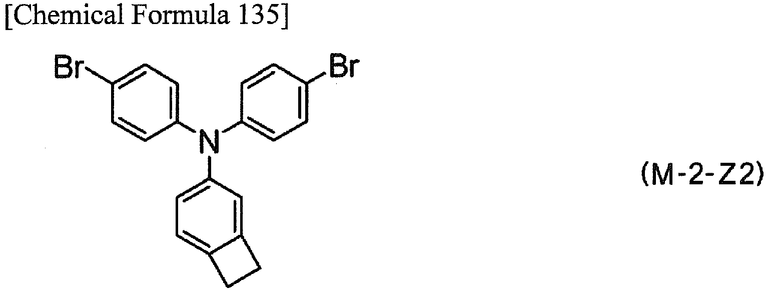 (156.3 mg, 0.364 mmol), dichlorobis(triphenylphosphine)palladium (4.9 mg), a 0.74 M toluene solution of quaternary ammonium chloride (Aliquat^{R} 336, product of Sigma-Aldrich Japan, KK., 3.1 mL) and toluene (50 mL), under an argon atmosphere, the mixture was heated to 105°C. To the reaction solution there was added dropwise aqueous sodium carbonate (2.0 M, 14 mL), and the mixture was refluxed for 16.5 hours. After the reaction, phenylboric acid (0.5 g) and toluene (140 mL) were added and reflux was continued for another 18.5 hours. Next, sodium diethyldithiocarbamate (0.75 g) and water (50 mL) were added. The obtained mixture was stirred in an oil bath (85°C) for 16 hours. The aqueous layer was removed from the obtained reaction product, and the organic layer was rinsed 3 times with water (100 mL) and then passed through a silica gel and basic alumina column. A procedure of precipitating the obtained solution in methanol was repeated twice, and then the resulting precipitate was filtered out and vacuum dried at 60°C to obtain 4.2 g of polymer compound J. The polystyrene-equivalent number-average molecular weight of polymer compound J was 4.40 × 10⁴, and the polystyrene-equivalent weight-average molecular weight was 1.24 × 10⁵.

### <Fabrication and evaluation of organic EL element>

### [Example 13]

A glass substrate with an ITO film formed to a thickness of 45 nm by sputtering was spin coated using a mixed solution of polythiophenesulfonic acid in ethyleneglycol monobutyl ether/water = 3/2 (trade name: Plexcore OC 1200 by Sigma-Aldrich Japan, KK.) to form a film with a thickness of 50 nm, and it was dried on a hot plate at 170°C for 15 minutes.

Next, polymer compound J synthesized in Synthesis Example 2 was spin coated on the film as a 0.7 wt% xylene solution, to form a film with a thickness of approximately 20 nm. It was then heat treated for 60 minutes on a hot plate at 180°C.

Next, polymer compound A synthesized in Example 5 was dissolved in a xylene solvent to a concentration of 1.3 wt%, and a film was formed on this film by spin coating at a rotational speed of 2100 rpm. The thickness of the obtained film was approximately 60 nm. This was dried for 10 minutes at 130°C under a nitrogen gas atmosphere, and then subjected to vacuum vapor deposition of sodium fluoride to about 3 nm and then aluminum to about 80 nm, as a cathode, to fabricate an organic EL element. For the vacuum vapor deposition, vapor deposition of the metals was initiated after the degree of vacuum fell to below 1 × 10⁻⁴ Pa.

When a voltage was applied to the obtained organic EL element, organic EL luminescence with a peak at 470 nm due to polymer compound A was obtained from the organic EL element. Luminescence from the organic EL element began from 2.6 V, and luminescence of 1000 cd/m² was exhibited at 4.2 V, with a maximum light-emitting efficiency of 11.9 cd/A.

### [Example 14]

An organic EL element was fabricated in the same manner as Example 13, except that instead of polymer compound A in Example 13, polymer compound B synthesized in Example 6 was dissolved in a xylene solvent to a concentration of 1.0 wt%, and a film was formed by spin coating at a rotational speed of 800 rpm. When a voltage was applied to the obtained organic EL element, organic EL luminescence with a peak at 470 nm due to polymer compound B was obtained. Luminescence from the organic EL element began from 2.7 V, and luminescence of 1000 cd/m² was exhibited at 4.5 V, with a maximum light-emitting efficiency of 14.2 cd/A.

### [Example 15]

An organic EL element was fabricated in the same manner as Example 13, except that instead of polymer compound A in Example 13, polymer compound C synthesized in Example 7 was dissolved in a xylene solvent to a concentration of 1.3 wt%, and a film was formed by spin coating at a rotational speed of 2100 rpm. When a voltage was applied to the obtained organic EL element, organic EL luminescence with a peak at 470 nm due to polymer compound C was obtained. Luminescence from the organic EL element began from 2.7 V, and luminescence of 1000 cd/m² was exhibited at 4.4 V, with a maximum light-emitting efficiency of 14.1 cd/A.

### [Example 16]

An organic EL element was fabricated in the same manner as Example 13, except that instead of polymer compound A in Example 13, polymer compound D synthesized in Example 8 was dissolved in a xylene solvent to a concentration of 1.3 wt%, and a film was formed by spin coating at a rotational speed of 2400 rpm. When a voltage was applied to the obtained organic EL element, organic EL luminescence with a peak at 470 nm due to polymer compound D was obtained. Luminescence from the organic EL element began from 2.7 V, and luminescence of 1000 cd/m² was exhibited at 4.4 V, with a maximum light-emitting efficiency of 9.6 cd/A.

### [Example 17]

An organic EL element was fabricated in the same manner as Example 13, except that instead of polymer compound A in Example 13, polymer compound E synthesized in Example 9 was dissolved in a xylene solvent to a concentration of 1.3 wt%, and a film was formed by spin coating at a rotational speed of 1600 rpm. When a voltage was applied to the obtained organic EL element, organic EL luminescence with a peak at 480 nm due to polymer compound E was obtained. Luminescence from the organic EL element began from 2.8 V, and luminescence of 1000 cd/m² was exhibited at 4.7 V, with a maximum light-emitting efficiency of 7.2 cd/A.

### [Example 18]

An organic EL element was fabricated in the same manner as Example 13, except that instead of polymer compound A in Example 13, polymer compound F synthesized in Example 10 was dissolved in a xylene solvent to a concentration of 1.3 wt%, and a film was formed by spin coating at a rotational speed of 1800 rpm. When a voltage was applied to the obtained organic EL element, organic EL luminescence with a peak at 475 nm due to polymer compound F was obtained. Luminescence from the organic EL element began from 2.8 V, and luminescence of 1000 cd/m² was exhibited at 4.7 V, with a maximum light-emitting efficiency of 7.6 cd/A.

### [Example 19]

An organic EL element was fabricated in the same manner as Example 13, except that instead of polymer compound A in Example 13, polymer compound G synthesized in Example 11 was dissolved in a xylene solvent to a concentration of 1.3 wt%, and a film was formed by spin coating at a rotational speed of 1290 rpm. When a voltage was applied to the obtained organic EL element, organic EL luminescence with a peak at 480 nm due to polymer compound G was obtained. Luminescence from the organic EL element began from 2.8 V, and luminescence of 1000 cd/m² was exhibited at 4.7 V, with a maximum light-emitting efficiency of 6.9 cd/A.

### [Example 20]

An organic EL element was fabricated in the same manner as Example 13, except that instead of polymer compound A in Example 13, polymer compound H synthesized in Example 12 was dissolved in a xylene solvent to a concentration of 1.3 wt%, and a film was formed by spin coating at a rotational speed of 1750 rpm. When a voltage was applied to the obtained organic EL element, organic EL luminescence with a peak at 480 nm due to polymer compound H was obtained. Luminescence from the organic EL element began from 2.8 V, and luminescence of 1000 cd/m² was exhibited at 5.0 V, with a maximum light-emitting efficiency of 8.0 cd/A.

### [Comparative Example 1]

An organic EL element was fabricated in the same manner as Example 13, except that instead of polymer compound A in Example 13, polymer compound I synthesized in Synthesis Example 1 was dissolved in a xylene solvent to a concentration of 1.3 wt%, and a film was formed by spin coating at a rotational speed of 2150 rpm. When a voltage was applied to the obtained organic EL element, organic EL luminescence with a peak at 480 nm due to polymer compound I was obtained. Luminescence from the organic EL element began from 3.2 V, and luminescence of 1000 cd/m² was exhibited at 5.6 V, with a maximum light-emitting efficiency of 6.3 cd/A.

## Claims

1. A polymer compound comprising a constitutional unit represented by the following formula (1-1) and/or formula (2-1); 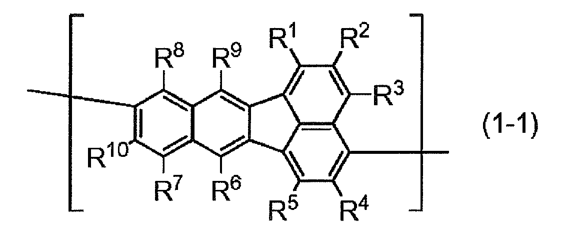 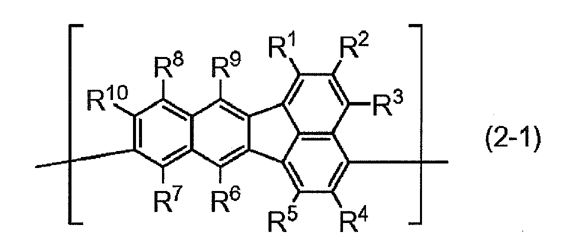 wherein R¹, R², R³, R⁴, R⁵, R⁶, R⁷, R⁸, R⁹ and R¹⁰ each independently represent a hydrogen atom, an optionally substituted alkyl group, an optionally substituted aryl group, an optionally substituted monovalent aromatic heterocyclic group, or a group represented by -O-R^{A}, where R^{A} represents an optionally substituted alkyl group, an optionally substituted aryl group or an optionally substituted monovalent aromatic heterocyclic group, and when multiple R^{A} groups are present, the R^{A} groups may be the same or different.

2. The polymer compound according to claim 1, which has an optionally substituted arylene group or an optionally substituted divalent aromatic heterocyclic group bonded to at least one of the two bonding sites of each of the constitutional units represented by the formula (1-1) and/or formula (2-1).

3. The polymer compound according to claim 2, wherein the arylene group is a 2,7-fluorenediyl group.

4. The polymer compound according to claim 2, wherein the arylene group is a 1,3-phenylene group.

5. The polymer compound according to any one of claims 1 to 4, wherein R⁶ and R⁹ in the formula (1-1) and formula (2-1) are each independently an optionally substituted aryl group or an optionally substituted monovalent aromatic heterocyclic group.

6. The polymer compound according to any one of claims 1 to 5, which comprises:
a first constitutional unit represented by the formula (1-1) and/or formula (2-1),
a second constitutional unit represented by the following formula (3), and
at least one constitutional unit selected from the group consisting of
a third constitutional unit represented by the following formula (4) and a fourth constitutional unit represented by the following formula (5); 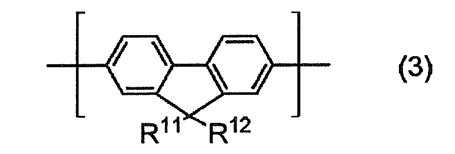 wherein R¹¹ and R¹² each independently represent an optionally substituted alkyl group, an optionally substituted aryl group or an optionally substituted monovalent aromatic heterocyclic group; 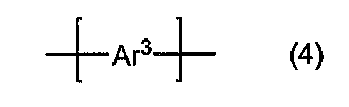 wherein Ar³ represents an arylene group having one or more optional substituents selected from among substituent group X, a divalent aromatic heterocyclic group having one or more optional substituents selected from among substituent group X, or a divalent group in which 2 or more of the same or different groups selected from the group consisting of arylene groups and divalent aromatic heterocyclic groups are linked, where the divalent group may have one or more substituents selected from among substituent group X;
<Substituent group X>
An alkyl group, an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a group represented by -N(R^{A})_{2,} a cyano group and a fluorine atom; where R^{A} is as defined in claim 1, and when multiple R^{A} groups are present, the R^{A} groups may be the same or different; 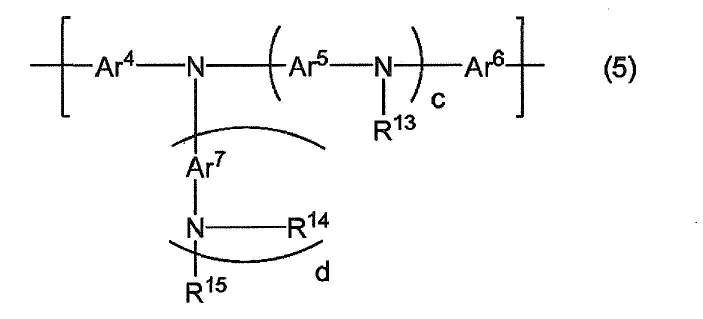 wherein Ar⁴, Ar⁵, Ar⁶ and Ar⁷ each independently represent an optionally substituted arylene group, an optionally substituted divalent aromatic heterocyclic group, or an optionally substituted divalent group in which 2 or more arylene groups or divalent aromatic heterocyclic groups are linked; R¹³, R¹⁴ and R¹⁵ each independently represent a hydrogen atom, an alkyl group, an aryl group, a monovalent heterocyclic group or an arylalkyl group; c represents an integer of 0-3, and d represents 0 or 1.

7. The polymer compound according to any one of claims 1 to 6, which comprises:
a first constitutional unit represented by the formula (1-1) and/or formula (2-1),
a second constitutional unit represented by the following formula (3), and
a fourth constitutional unit represented by the following formula (5); 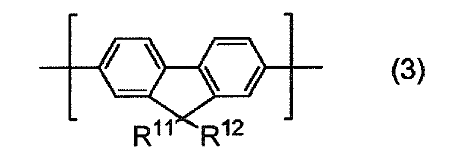 wherein R¹¹ and R¹² have the same respective definitions as in according to claim 6; 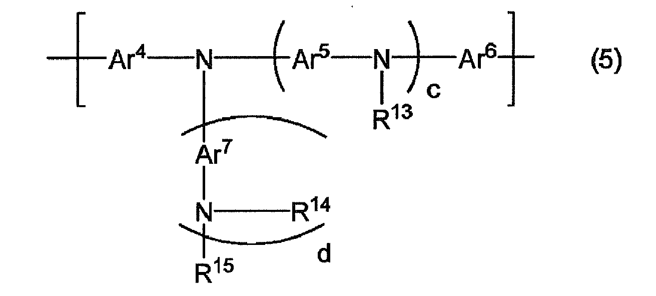 wherein Ar⁴, Ar⁵, Ar⁶, Ar⁷, R¹³, R¹⁴, R¹⁵, c and d have the same respective definitions as in claim 6.

8. The polymer compound according to any one of claims 1 to 7, wherein the polymer compound is a conjugated polymer compound.

9. The polymer compound according to any one of claims 6 to 8, wherein the total content of first constitutional units represented by the formula (1-1) and formula (2-1) in the polymer compound is between 0.1 mol% and 20 mol% based on the total content of the first constitutional unit, the second constitutional unit, the third constitutional unit and the fourth constitutional unit.

10. The polymer compound according to any one of claims 6 to 9, wherein the total content of the first constitutional unit, the second constitutional unit, the third constitutional unit and the fourth constitutional unit in the polymer compound is 80 wt% or greater based on the total amount of the polymer compound.

11. A compound represented by the following formula (6) and/or formula (7); 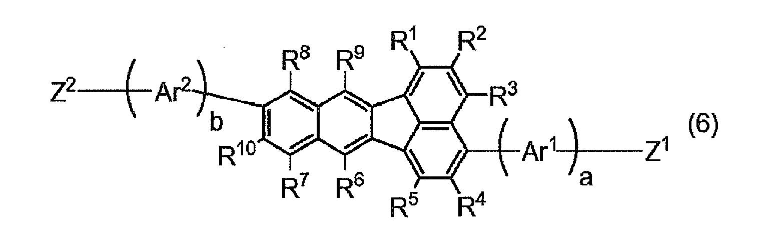 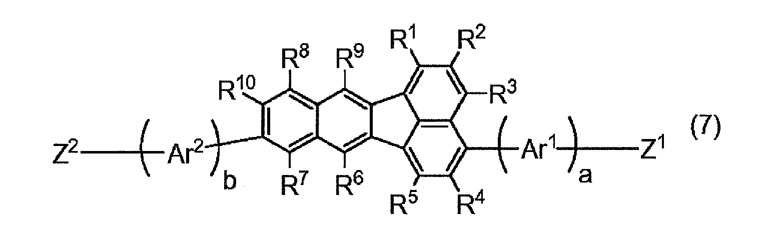 wherein R¹, R², R³, R⁴, R⁵, R⁶, R⁷, R⁸, R⁹ and R¹⁰ have the same respective definitions as in claim 1, Ar¹ and Ar² each independently represent an optionally substituted arylene group or an optionally substituted divalent aromatic heterocyclic group, and a and b each independently represent 0 or 1; Z¹ and Z² each independently represent substituent group A or substituent group B;
<Substituent group A>
A chlorine atom, a bromine atom, an iodine atom and a group represented by -O-S(=O)₂R¹⁶, where R¹⁶ represents an optionally substituted alkyl group, or an aryl group optionally substituted with an alkyl group , an alkoxy group , a nitro group, a fluorine atom or a cyano group;
<Substituent group B>
A Group represented by -B(OR¹⁷)₂, where R¹⁷ represents a hydrogen atom or an alkyl group, and the two R¹⁷ groups may be the same or different and may be bonded together to form a ring,
a group represented by -BF₄Q¹, where Q¹ represents a monovalent cation of lithium, sodium, potassium, rubidium or cesium,
a group represented by -MgY¹, where Y¹ represents a chlorine atom, a bromine atom or an iodine atom,
a group represented by -ZnY², where Y² represents a chlorine atom, a bromine atom or an iodine atom; and
a group represented by -Sn(R¹⁸)₃, where R¹⁸ represents a hydrogen atom or an alkyl group, and the three R¹⁸ groups may be the same or different and may be bonded together to form a ring.

12. The compound according to claim 11, wherein R⁶ and R⁹ in the formula (6) and/or formula (7) are each independently an optionally substituted aryl group or an optionally substituted monovalent aromatic heterocyclic group.

13. A method for producing the polymer compound according to any one of claims 1 to 10, by polymerization of a monomer composition comprising a first monomer represented by the following formula (6) and/or formula (7), and a second monomer represented by the following formula (3M); 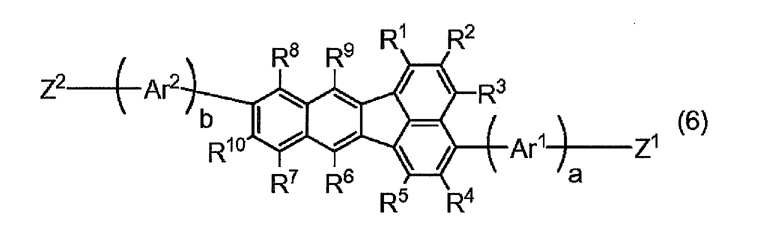 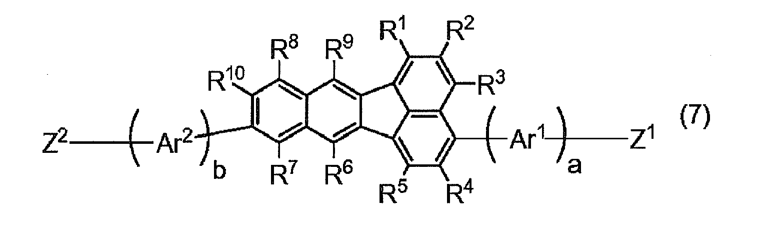 wherein R¹, R², R³, R⁴, R⁵, R⁶, R⁷, R⁸, R⁹ R¹⁰, Ar¹, Ar², a, b, Z¹ and Z² have the same definitions as in claim 11; 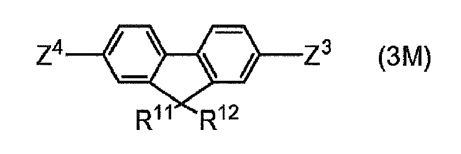 wherein R¹¹ and R¹² have the same respective definitions as in claim 6, and Z³ and Z⁴ each independently represent substituent group A or substituent group B in claim 11.

14. A polymer composition comprising the polymer compound according to any one of claims 1 to 10, and at least one material selected from the group consisting of hole transport materials, electron transport materials and light-emitting materials.

15. A solution comprising the polymer compound according to any one of claims 1 to 10, or the polymer composition according to claim 14.

16. An organic film comprising the polymer compound according to any one of claims 1 to 10, or the polymer composition according to claim 14.

17. A light-emitting device comprising the organic film according to claim 16.

18. A surface light source comprising the light-emitting device according to claim 17.

19. A display device comprising the light-emitting device according to claim 17.
